(19) Europäisches Patentamt

European Patent Office

Office européen des brevets

(11) **EP 1 069 600 A1**

(12) **EUROPEAN PATENT APPLICATION**
published in accordance with Art. 158(3) EPC

(43) Date of publication:
17.01.2001 Bulletin 2001/03

(51) Int. Cl.$^7$: **H01L 21/027**, G03F 7/20

(21) Application number: 99909301.6

(86) International application number:
PCT/JP99/01442

(22) Date of filing: 23.03.1999

(87) International publication number:
WO 99/49505 (30.09.1999 Gazette 1999/39)

(84) Designated Contracting States:
AT BE CH CY DE DK ES FI FR GB GR IE IT LI LU
MC NL PT SE

(30) Priority: 24.03.1998 JP 9385898
19.06.1998 JP 18810098
11.01.1999 JP 393299

(71) Applicant: NIKON CORPORATION
Tokyo 100-0005 (JP)

(72) Inventors:
• KOMATSUDA, Hideki,
Nikon Corporation
Tokyo 100-0005 (JP)

• KANAYAMAYA, Nobumichi,
Nikon Corporation
Tokyo 100-0005 (JP)
• TANITSU, Osamu,
Nikon Corporation
Tokyo 100-0005 (JP)
• SHIBUYA, Masato,
Nikon Corporation
Tokyo 100-0005 (JP)

(74) Representative:
Burke, Steven David et al
R.G.C. Jenkins & Co.
26 Caxton Street
London SW1H 0RJ (GB)

(54) **ILLUMINATOR, EXPOSING METHOD AND APPARATUS, AND DEVICE MANUFACTURING METHOD**

(57) An illumination apparatus for illuminating a surface to be illuminated with radiation comprises a radiation source (1) for generating a beam of radiation having a predetermined wavelength, a wavefront division type optical integrator (151) including a plurality of unit optical systems, a condenser optical system (9,11) for guiding the beams of radiation from the wavefront division type optical integrator to the surface to be illuminated, and a plurality of auxiliary optical members (OMA) for deflecting the beams of radiation through the unit optical systems. At least one of the auxiliary optical members is disposed corresponding to one of the unit optical systems.

FIG. 1

**Description**

BACKGROUND OF THE INVENTION

Field of the Invention

The present invention relates to a projection exposure apparatus used for a lithography process in a manufacturing line of a semiconductor device and a liquid crystal display device. The present invention also relates to an illumination apparatus used for this type of projection exposure apparatus. The present invention further relates to a projection exposure method using the same projection exposure apparatus in the lithography process. The present invention still further relates to a device manufacturing method of manufacturing a semiconductor device, an imaging device such as a CCD etc. a liquid crystal display device or a thin-film magnetic head, and so on, by transferring a device pattern on a mask onto a photosensitive substrate with use of such a projection exposure apparatus.

Related Background Art

A projection exposure apparatus for transferring a pattern on a reticle serving as a mask with reduction magnification onto each shot area of a wafer on which a photo resist is applied when manufacturing, e.g., a semiconductor device, may involve the use of a reduction projection exposure apparatus (a stepper) classified as a step-and-repeat type (a batch exposure type), and a so-called step-and-scan type projection exposure apparatus for sequentially transferring a reduced image of the reticle pattern onto the respective shot areas on the reticle by synchronously scanning the reticle and the wafer through a projection optical system in a state where a part of the reticle pattern is projected with reduction magnification on the wafer through the projection optical system.

In an illumination apparatus used in each of those projection exposure apparatuses, a fly's eye lens and an optical integrator such as a rod type optical integrator are used for uniformizing an intensity distribution of the illumination radiation falling on the reticle.

Now, over the recent years, a performance such as a resolution etc required of those projection exposure apparatuses is getting extremely close to a limit to which it can be theoretically calculated. Set values of constants (a numerical aperture of a projection lens, a numerical aperture of an illumination system etc) of an optimal optical system, are different depending on a type of the reticle pattern. It is therefore required of the projection exposure apparatus that the constants of the optimal optical system can be selected in accordance with the type of the reticle pattern.

This type of projection exposure apparatus is disclosed in publications of, e.g., Japanese Patent Application Laid-Open Nos.59-155843 and 6-61121.

Further, what has been conducted over the recent years is that an intensity distribution of a planar radiation source (a surface illuminant) formed on a surface conjugate with a pupil surface of the projection optical system, is set so that the radiation intensity becomes larger in peripheral portions than at a central portion, and an image contrast in the vicinity of a limit of the resolution is enhanced, i.e., a so-called modified illumination (oblique illumination) is effected. Herein, it can be considered that a central portion of an aperture stop (σ-stop) in the illumination apparatus is, for example, shielded from the radiation or dimmed in radiation beam in order to change the intensity distribution of the planar radiation source. In this case, however, there arises a problem, wherein a decline of illuminance on the reticle is brought about due to the radiation shielding or dimming, and as a result a throughput decreases.

In publication of Japanese Patent Application Laid-Open No. 5-207007 is proposed a technology for reducing the decrease in throughput. A problem inherent in the technology disclosed in this Publication is, however, that the projection exposure apparatus increases in size involving a rise in its manufacturing cost, and an installation space is hard to ensure.

SUMMARY OF THE INVENTION

It is a primary object of the present invention to reduce a decline of illuminance when performing a modified illumination without largely changing an architecture of the projection exposure apparatus used at the present.

To accomplish the above object, according to the present invention, an illumination apparatus for illuminating a surface to be illuminated with radiation, comprises a radiation source for generating a beam of radiation having a predetermined wavelength, a wavefront division type optical integrator, including a plurality of unit optical systems, for wavefront-dividing the beam of radiation from the radiation source an forming a plurality of radiation source images from a plurality of wavefront-divided radiation beams, a condenser optical system for leading the beams of radiation from the wavefront division type optical integrator to the surface to be illuminated, and a plurality of auxiliary optical members for deflecting the beams of radiation through the unit optical systems. At least one of the auxiliary optical members is disposed corresponding to one of the unit optical systems.

According to a preferable mode of the present invention, in the above illumination apparatus, the plurality of auxiliary optical members may be disposed in a one-to-one correspondence relation with each of the all unit optical systems.

In the above illumination apparatus, the plurality of auxiliary optical members may be disposed between the wavefront division type optical integrator and the surface to be illuminated.

In the above illumination apparatus, the auxiliary optical member may deflect the beam of radiation through the unit optical system in at least two directions.

In the above illumination apparatus, an auxiliary optical integrator for forming a substantial planar radiation source on the basis of the radiation from the plurality of illuminant images by the wavefront division type optical integrator, may be disposed between the wavefront division type optical integrator and the condenser optical system, and the condenser optical system may guide the radiation from the substantial planar radiation source by the auxiliary optical integrator, to the surface to be illuminated.

In the above illumination apparatus, at least some of the beams of radiation deflected by the auxiliary optical members may be guided to an area that does not contain the optical axis on a predetermined surface.

Further, a projection exposure apparatus for illuminating a mask by use of an illumination apparatus for supplying exposure radiation, and projecting a pattern on the mask onto a workpiece through a projection optical system, comprises the illumination apparatus described above, wherein the predetermined surface is conjugate with a pupil surface of the projection optical system or with a portion in the vicinity of the pupil surface.

Moreover, according to the present invention, an illumination apparatus for illuminating a surface to be illuminated with radiation, comprises a radiation source for generating a beam of radiation having a predetermined wavelength, a wavefront division type optical integrator for wavefront-dividing the beam of radiation from the radiation source an forming a plurality of illuminant images from a plurality of wavefront-divided radiation beams, a condenser optical system for leading the beams of radiation from the wavefront division type optical integrator to the surface to be illuminated, and a radiation deflection member for deflecting the plurality of wavefront-divided beams of radiation in at least two or more directions different from each other.

According to a preferable mode of the present invention, in the illumination apparatus described above, the wavefront division type optical integrator may be formed integrally with the radiation deflection member.

In the illumination apparatus described above, an auxiliary optical integrator for forming a substantial planar radiation source on the basis of the plurality of radiation sources formed by the wavefront division type optical integrator, may be disposed between the wavefront division type optical integrator and the surface to be illuminated, and a radiation diffusion member (a diffusive optical member) may be disposed closer to the radiation source than the auxiliary optical integrator.

The above illumination apparatus may further comprise another optical integrator, so provided as to be exchangeable with at least the wavefront division type optical integrator, for forming a substantial planar radiation source on the basis of the beam of radiation from the radiation source.

In the illumination apparatus described, another optical integrator may be so provided as to be exchangeable with the wavefront division type optical integrator and the radiation deflection member.

In the above illumination apparatus, another optical integrator may be so provided as to be exchangeable with only the wavefront division type optical integrator.

In the illumination apparatus described above, the wavefront division type optical integrator and the radiation deflection member may be optical members different from each other.

In the illumination apparatus described above, the radiation deflection member may include at least one auxiliary optical member for deflecting only one beam of radiation among the plurality of wavefront-divided beams of radiation.

Further, in the above illumination apparatus, the radiation deflection member may include the plurality of auxiliary optical members, and the auxiliary optical member may be formed integrally with the wavefront division type optical integrator.

In the illumination apparatus described above, the radiation deflection member may include a first auxiliary optical member for deflecting at least one beam of radiation among the plurality of wavefront-divided beams of radiation in at least two directions, and a second auxiliary optical member for deflecting another beam of radiation different from at least the above one beam of radiation among the plurality of beams of radiation in at least two directions.

In the above illumination apparatus, the two directions by the first auxiliary optical member may be the same as the two directions by the auxiliary optical member. Moreover, in the illumination apparatus described above, the first auxiliary optical member and the second auxiliary optical member may be disposed apart from the wavefront division type optical integrator.

In the illumination apparatus described, the radiation deflection member may include a first auxiliary optical member for deflecting only one beam of radiation among the plurality of wavefront-divided beams of radiation, and a second auxiliary optical member for deflecting only another beam of radiation different from the above one beam of radiation among the plurality of wavefront-divided beams of radiation.

In the above illumination apparatus, the radiation deflection member may include a first auxiliary optical member for leading at least one beam of radiation among the plurality of wavefront-divided beams of radiation onto a first area on a predetermined surface, and a second auxiliary optical member for deflecting another beam of radiation different from at least the above one beam of radiation among the plurality of wavefront-divided beams of radiation onto a second area on the predetermined surface, and areal sizes of the first and second areas may be different from each other.

Further, in the above illumination apparatus, the wavefront division type optical integrator may include a first unit optical system having a first focal length, and a second unit optical system having a second focal length different from the first focal length.

In the illumination apparatus, the plurality of beams of radiation deflected by the radiation deflection member may contain a first beam of radiation having a first inclination to an axis parallel to the optical axis of the illumination apparatus, and a second beam of radiation having a second inclination different from the first inclination.

In the illumination apparatus described above, an auxiliary optical integrator for forming a substantial planar radiation source on the basis of the beams of radiation from the plurality of illuminant images by the wavefront division type optical integrator, may be disposed between the wavefront division type optical integrator and the condenser optical system, and the condenser optical system may guide the radiation from the substantial planar radiation source by the auxiliary optical integrator onto the surface to be illuminated.

In the above illumination apparatus, the radiation deflection member may have a plurality of auxiliary optical member groups, the auxiliary optical member group, when n is a natural number, may have 4n-pieces of auxiliary optical members, an exit surface of each of the auxiliary optical members may be inclined to a fiducial surface perpendicular to the optical axis of the illumination apparatus, and when a straight line formed by projecting a normal line of the exit surface of the auxiliary optical member on the fiducial surface is set as an azimuth straight line, an angle made by the azimuth straight lines of the auxiliary optical members in the auxiliary optical member group, may be 360/4n degrees.

In the above illumination apparatus, each of the auxiliary optical member groups may consist of four pieces of the auxiliary optical members, and an angle made by the azimuth straight lines of the four auxiliary optical members in the auxiliary optical member group, may be 90 degrees.

In the illumination apparatus described above, the plurality of auxiliary optical member groups may include a first auxiliary optical member group and a second auxiliary optical member group, an angle made by a set of the azimuth straight lines of the four auxiliary optical members in the first auxiliary optical member group and by a set of the azimuth straight lines of the four auxiliary optical members in the second auxiliary optical member group, may be 45 degrees.

In the illumination apparatus described above, the beam of radiation through the first auxiliary optical member group may be guided onto the first area on the predetermined surface, and the beam of radiation through the second auxiliary optical member group may be guided onto the second area on the predetermined surface, and areal sizes of the first and second areas may be different from each other.

In the illumination apparatus described above, the first and second areas may be at least partially overlapped with each other on the predetermined surface.

In the above illumination apparatus, the wavefront division type optical integrator may have a plurality of unit optical systems provided corresponding respectively to the auxiliary optical members, and a focal length of each of the unit optical systems corresponding to the first auxiliary optical member group may be different from a focal length of each of the unit optical systems corresponding to the second auxiliary optical member group.

In the illumination apparatus described above, when an angle made by the fiducial surface and the exit surface of the auxiliary optical member within a plane containing the azimuth straight line and the straight line parallel to the optical axis, is set as an apex angle of the auxiliary optical member, the plurality of auxiliary optical members may include a first auxiliary optical member having a first apex angle and a second auxiliary optical member having a second apex angle different from the first apex angle.

In the above illumination apparatus, at least one beam of radiation among the plurality of beams of radiation deflected by the radiation deflection member, may be guided onto an area that does not contain the optical axis on the predetermined surface.

According to a preferable mode of the present invention, a projection exposure apparatus for illuminating a mask with the radiation by use of an illumination apparatus for supplying exposure radiation, and projecting a pattern on the mask on a workpiece through a projection optical system, comprises the illumination apparatus described above, and a predetermined surface is conjugate with a pupil surface of the projection optical system or a portion in the vicinity of the pupil surface.

In the above projection exposure apparatus, a radiation intensity distribution on the predetermined surface may be a distribution in which a radiation intensity in an area that does not contain the optical axis is larger than in an area containing the optical axis. Further, in the above projection exposure apparatus, the radiation intensity distribution on the predetermined surface may contain any one of an annular configuration, a bipolar configuration and a quadrupolar configuration.

In the illumination apparatus described above, an auxiliary optical integrator for forming a substantial planar radiation source on the basis of the beams of radiation from the plurality of illuminant images by the wavefront division type optical integrator, may be disposed between the wavefront division type optical integrator and the condenser optical system, and the condenser optical system may guide the radiation from the substantial planar radiation source by the auxiliary optical integrator onto the surface to be illuminated.

The illumination apparatus described above may further comprise a relay optical system for leading the beam of radiation from the wavefront division type optical integrator to the auxiliary optical integrator, and an aperture stop having at least two or more apertures, wherein each of the beams of radiation deflected in at least two or more directions different from each other by the radiation deflection member, may pass through at least two or more apertures.

The illumination apparatus described above may further comprise an aperture stop disposed between the auxiliary optical integrator and the surface to be illuminated and having at least two or more apertures, wherein the auxiliary optical integrator may be a wavefront division type optical integrator having a plurality of unit optical systems, the beams of radiation deflected in at least the two or more directions different from each other by the radiation deflection member, may be overlapped with each other on at least two areas on an exit surface of the auxiliary optical integrator, and incident surfaces of at least two unit optical systems corresponding respectively to two or more apertures among the plurality of unit optical systems in the auxiliary optical integrator, may be embraced respectively by at least two areas.

In the illumination apparatus described above, the auxiliary optical integrator may be an internal surface reflection type optical integrator, and the respective beams of radiation defected in at least the two or more directions different from each other by the radiation deflection member, may be incident on the internal surface reflection type optical integrator in at least two or more directions different from each other.

In the above illumination apparatus, the radiation deflection member may take a configuration containing at least partially a cone shape.

In the illumination apparatus described above, the cone shape may be at least a part of a conical shape.

In the illumination apparatus described above, an inclined surface of the conical shape may be a surface obtained by rotating a straight line about a predetermined axis.

In the above illumination apparatus, the inclined surface of the conical shape may be a surface obtained by rotating a curved line about a predetermined axis.

In the above illumination apparatus, the radiation deflection member may include a first auxiliary optical member containing at least partially a conical shape, and a second auxiliary optical member containing at least partially a conical shape, and an angle, corresponding to an apex angle of the conical shape, of the first auxiliary optical member and an angle, corresponding to an apex angle of the conical shape, of the second auxiliary optical member, may be different from each other.

In the illumination apparatus described above, the conical portion may be at least a part of a polygonal cone (pyramid).

In the illumination apparatus described above, an inclined surface of the polygonal cone may be a flat surface.

In the above illumination apparatus, an inclined surface of the polygonal cone may be a curved surface.

In the above illumination apparatus, the radiation deflection member may include a first auxiliary optical member containing at least partially a polygonal cone shape, and a second auxiliary optical member containing at least partially a polygonal cone shape, and an angle made by the inclined surface and a normal line of a bottom surface of the polygonal cone of the first auxiliary optical member and an angle made by the inclined surface and a normal line of a bottom surface of the polygonal cone of the second auxiliary optical member, may be different from each other.

In the illumination apparatus, the polygonal cone shape may include a first inclined surface in which the angle made by the normal line of the bottom surface of the polygonal cone shape is a first angle, and a second inclined surface in which the angle made by the normal line of the bottom surface of the polygonal cone shape is a second angle different from the first angle.

According to a preferable mode of the present invention, a projection exposure apparatus for illuminating a mask with the radiation by use of an illumination apparatus for supplying exposure radiation, and projecting a pattern on the mask on a workpiece through a projection optical system, comprise the illumination apparatus described above, wherein the radiation source supplies the exposure radiation.

The above projection exposure apparatus may further comprise another optical integrator, so provided as to be exchangeable with at least the wavefront division type optical integrator, for forming a substantial planar radiation source on the basis of the beams of radiation from the radiation source.

The projection exposure apparatus described above may further comprise an input unit for inputting data about a type of the mask, and the wavefront division type optical integrator may be replaced with another optical integrator on the basis of the data given from the input unit.

In the above projection exposure apparatus, the input unit may be a console.

In the above projection exposure apparatus, the input unit may read a mark formed on the mask.

According to a preferable mode of the present invention, an exposure method of illuminating a mask with exposure radiation in an ultraviolet region and projecting a pattern on the mask on a workpiece through a projection optical system, comprises a step of using the projection exposure apparatus described above.

The above exposure method may further comprise a step of inputting data about a type of the mask, and a step of exchanging a wavefront division type optical integrator with another optical integrator on the basis of the data inputted.

According to a preferable mode of the present invention an exposure method comprises a step of illuminating a mask with exposure radiation in an ultraviolet region, and a step of projecting a device pattern on the mask on a workpiece through a projection optical system, wherein the step of projecting the device pattern on the workpiece is executed by use of the projection exposure apparatus described above.

According to a preferable mode of the present invention, an exposure method of illuminating a mask with exposure radiation in an ultraviolet region and projecting a pattern on the mask on a workpiece through a projection optical system, comprises a step of using the projection exposure apparatus described above.

According to a preferable mode of the present invention, an exposure method comprises a step of illuminating a mask with exposure radiation in an ultraviolet region, and a step of projecting a device pattern on the mask on a workpiece through a projection optical system, wherein the step of projecting the device pattern on the workpiece is executed by use of the projection exposure apparatus described above.

According to a preferable mode of the present invention, an illumination apparatus for illuminating a surface to be illuminated with the radiation, comprises a radiation source for generating a beam of radiation having a predetermined wavelength, a radiation deflection member for wavefront-dividing the beam of radiation emitted from the radiation source into at least six beams of radiation, and deflecting at least the six beams of radiation subjected to the wavefront division in directions different from each other, an optical integrator for forming a planar radiation source in a predetermined configuration on the basis of the beams of radiation via the radiation deflection member, and a condenser optical system for leading the beams of radiation from the wavefront-division type optical integrator onto the surface to be illuminated, wherein at least some of at least the six beams of radiation deflected by the radiation deflection member are guided onto an area that does not contain the optical axis on a predetermined surface.

According to a preferable mode of the present invention, a projection exposure apparatus for illuminating a mask with the radiation by use of an illumination apparatus for supplying exposure radiation and projecting a pattern on the mask on a workpiece through a projection optical system, comprises the illumination apparatus described above, wherein a predetermined surface is conjugate with a pupil surface of the projection optical system or a portion in the vicinity of the pupil surface.

In the above illumination apparatus, a radiation intensity distribution on a surface (a pupil surface of the illumination apparatus) having a relation of Fourier transform with the surface to be illuminated or on a surface in the vicinity of the former surface, may be substantially an ununiform distribution. Note that the substantially ununiform distribution implies that in the radiation intensity distribution on the (pupil) surface or on the surface in the vicinity of this surface, a radiation intensity in the area containing the optical axis of the illumination apparatus is substantially different from a radiation intensity in an area that does not contain the optical axis.

According to a further preferable mode of the present invention, a projection exposure apparatus for illuminating a mask with the radiation by use of an illumination apparatus for supplying exposure radiation and projecting a pattern on the mask on a workpiece through a projection optical system, comprises the illumination apparatus described above, wherein a surface having a relation of Fourier transform is substantially conjugate with a pupil surface of the projection optical system.

In the above illumination apparatus, the plurality of auxiliary optical members may be disposed between the unit optical systems and the surface to be illuminated.

According to a preferable mode of the present invention, the radiation source emits beams of radiation in which a sum of a solid angle with the radiation beams expanding and an areal size of the radiation beams is almost zero.

BRIEF DESCRIPTION OF THE DRAWINGS

FIG. 1 is a view showing an optical system of a projection exposure apparatus in a first embodiment of the present invention;

FIG. 2A is a view showing a layout of a first fly's eye lens in the first embodiment;

FIG. 2B is a view showing a layout of an aperture stop;

FIGS. 3A - 3D are views each showing a configuration of a conventional fly's eye lens;

FIG. 3E is a view showing an illumination area thereof;

FIGS. 4A and 4B are explanatory views showing an azimuth angle;

FIG. 5 is an explanatory view showing a deviation angle of a lens element;

FIGS. 6A - 6J are explanatory views showing the lens elements:

FIG. 6K is an explanatory view showing an illumination area thereof;

FIGS. 7A - 7F are explanatory views showing other lens elements;

FIG. 7G is an explanatory view showing an illumination area thereof;

FIG. 8 is a view showing a modified example of the first embodiment;

FIG. 9 is a view showing an optical system of the fly's eye lens in the projection exposure apparatus in a second embodiment;

FIG. 10A is a view showing a layout of the first fly's eye lens in a second embodiment;

FIG. 10B is a view showing a layout of an aperture stop;

FIGS. 11A - 11C are views each showing a configuration of the lens element;

FIG. 11D is a view showing an illumination area thereof;

FIGS. 12A and 12B are views each showing a layout of the lens element of the first fly's eye lens and a lemon skin filter; FIG. 12C is a view showing an illumination area when using the lemon skin filter;

FIGS. 13A - 13D are views showing a process of manufacturing the lemon skin filter;

FIGS. 14A - 14J are views showing other lens elements;

FIG. 14K is a view showing an illumination area thereof;

FIG. 15A is a view showing a layout of the first fly's eye lens in a third embodiment;

FIG. 15B is a view showing a layout of the aperture stop;

FIGS. 16A - 16D are views showing the lens elements;

FIGS. 16E and 16F are views each showing an azimuth angle;

FIG. 16G is a view showing an illumination area thereof;

FIGS. 17A - 17D and 17F - 17I are views showing the lens elements;

FIGS. 17E and 17J are views each showing the azimuth angle;

FIG. 17K is a view showing an array;

FIG. 17L is a view showing an illumination area thereof;

FIG. 18A is a view showing an optical system of the fly's eye lens in the projection exposure apparatus in a fourth embodiment;

FIG. 18B is a view showing a relation between the first fly's eye lens and a deflection prism;

FIG. 19 is a view showing constructions of an illumination apparatus in a fifth embodiment and of the projection exposure apparatus including the same illumination apparatus;

FIG. 20A is a view showing a configuration of a revolver provided with the first fly's eye lens;

FIG. 20B is a view showing a configuration of a revolver provided with an aperture stop;

FIGS. 21A - 21C are views each showing a relation between the first fly's eye lens and a conical shaped optical member;

FIG. 22A is a view showing action of a prism of the optical member;

FIG. 22B is a view showing an illumination area thereof;

FIG. 22C is a view showing an optical path of a radiation beam penetrating the fly's eye lens and the conical shaped optical member;

FIG. 22D is a view showing an illumination area thereof;

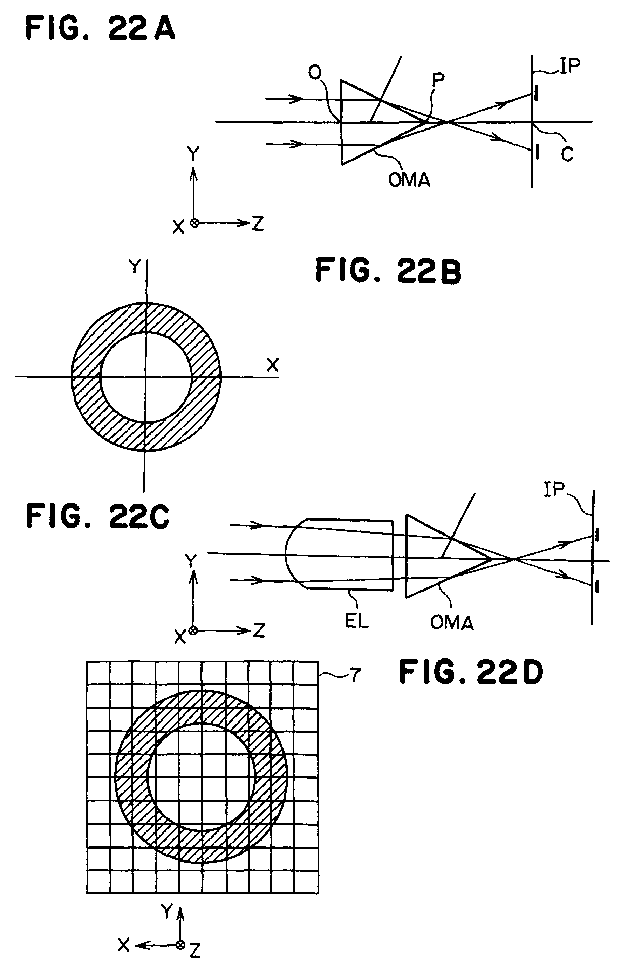

FIGS. 22A - 23E are views each showing an intensity distribution on a predetermined surface;

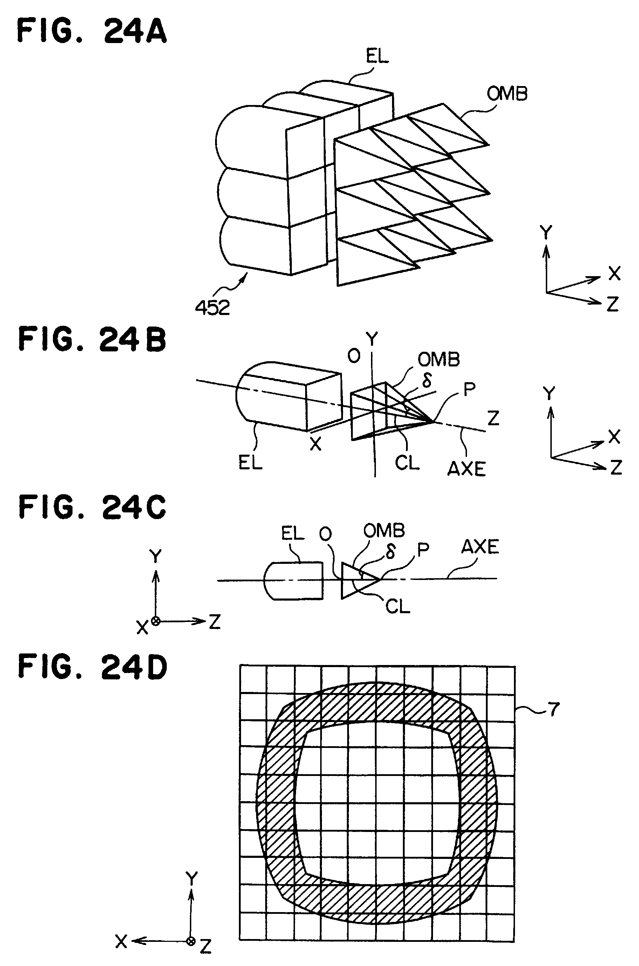

FIGS. 24A - 24C are views each showing a relation between the first fly's eye lens and a square cone shaped optical member;

FIG. 24D is a view showing an illumination area on a predetermined surface;

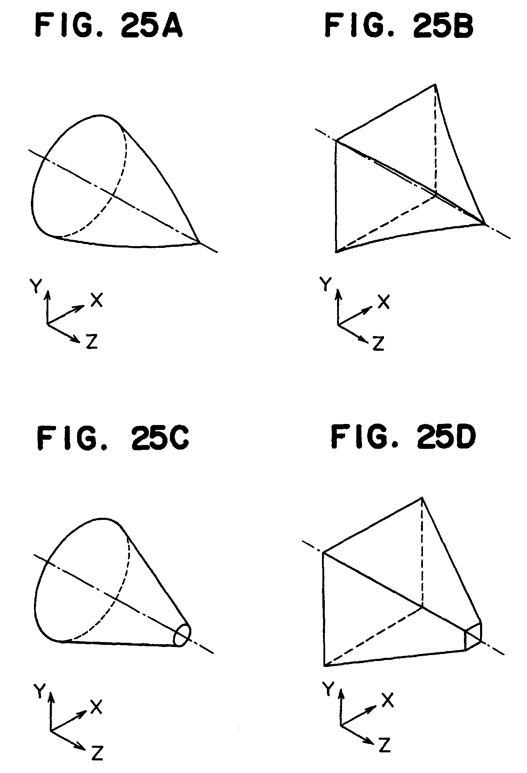

FIGS. 25A - 25D are views each showing a modified example of the optical member taking a conical shape;

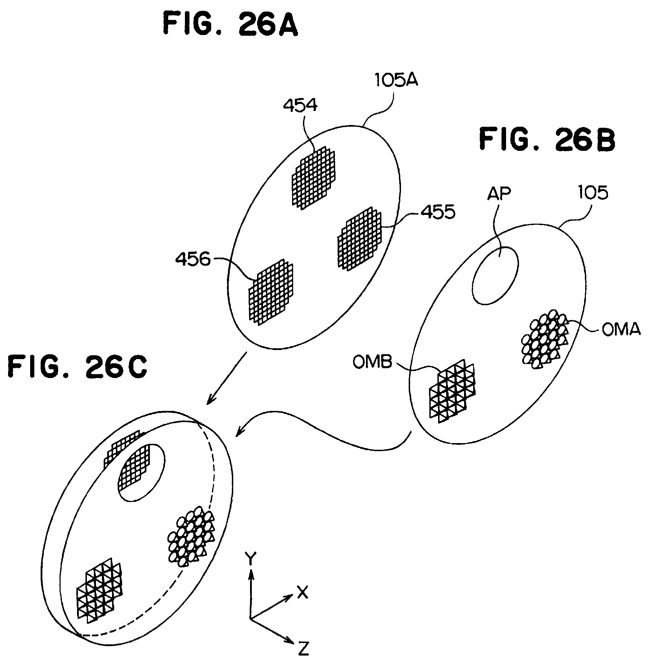

FIGS. 26A - 26C are views each showing an example where the revolver (turret) is provided with the first fly's eye lens and the optical member, respectively;

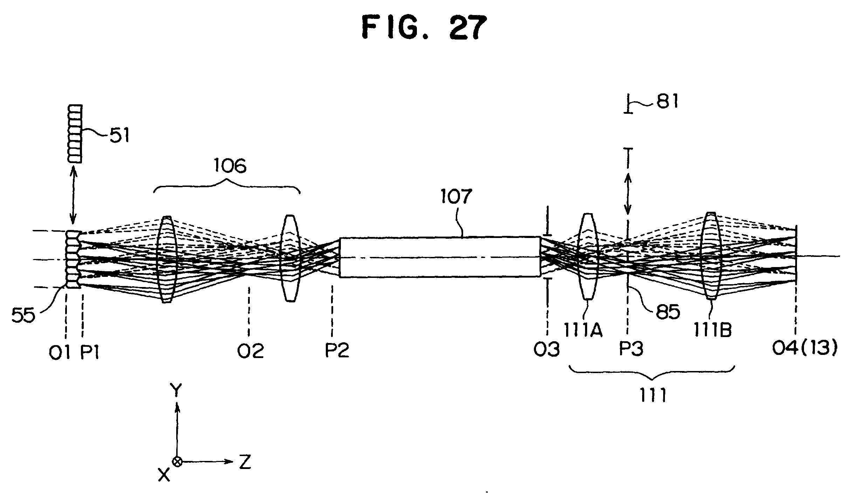

FIG. 27 is a view showing an outline of a construction of the projection exposure apparatus in a sixth embodiment; and

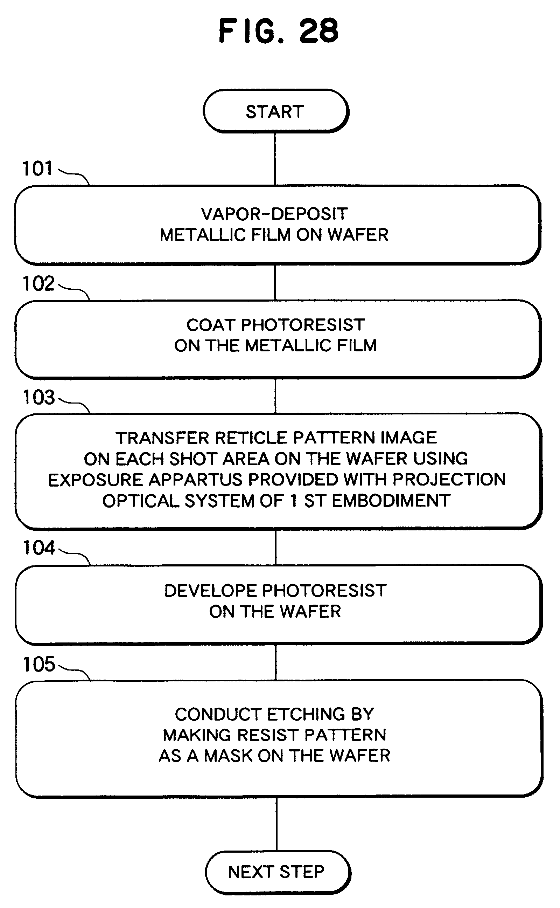

FIG. 28 is an explanatory flowchart showing a process of an exposure of a predetermined circuit pattern.

## DESCRIPTION OF THE PREFERRED EMBODIMENTS

Embodiments of the present invention will hereinafter be described with reference to the accompanying drawings.

(First Embodiment)

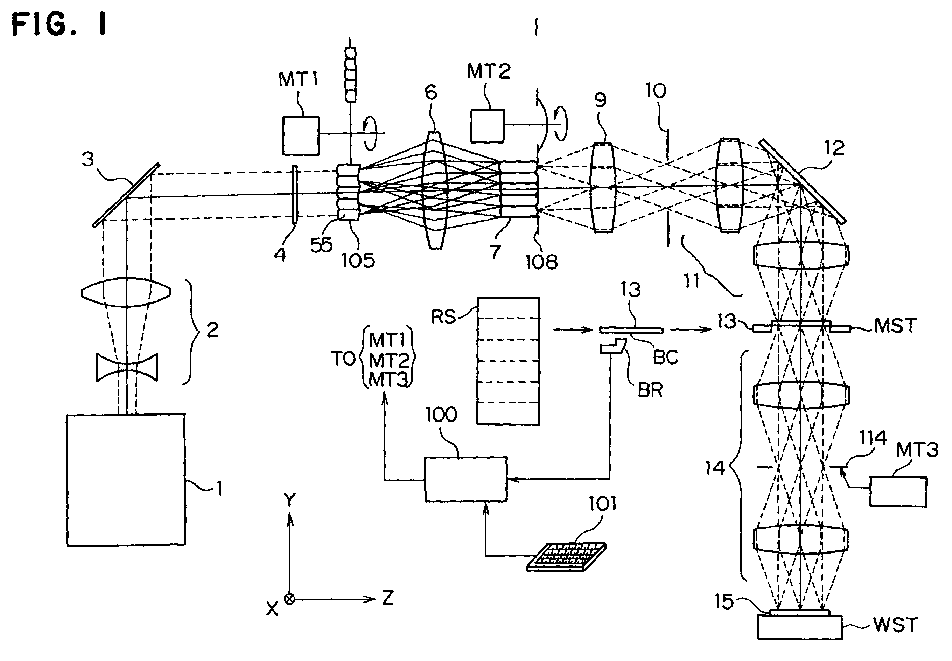

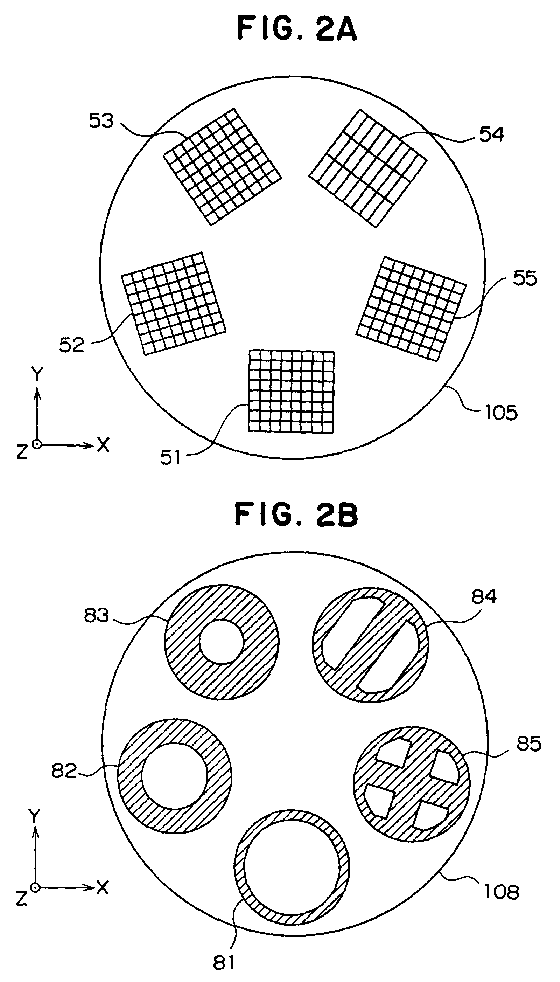

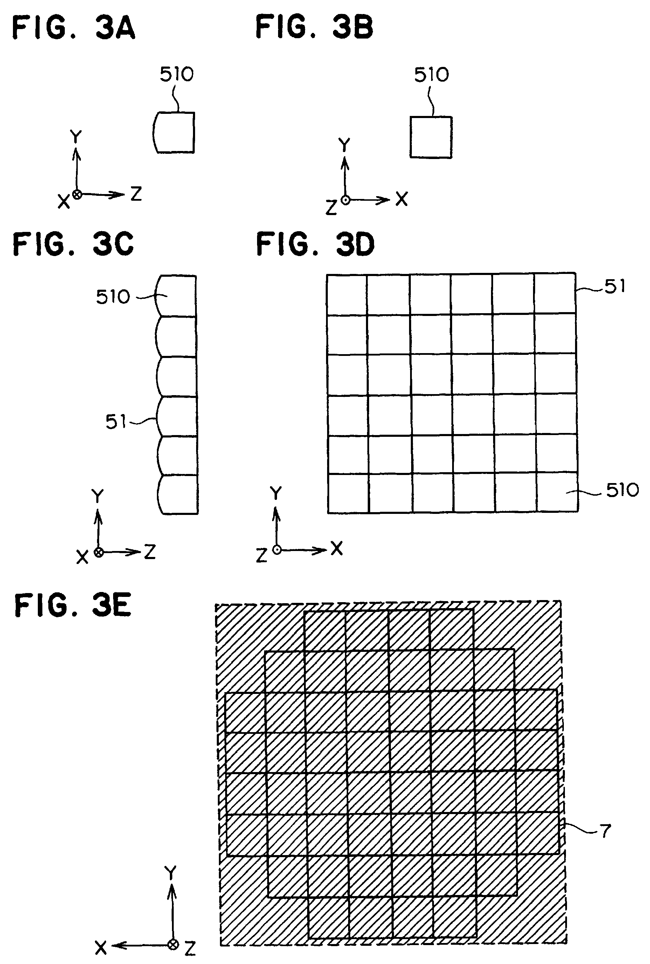

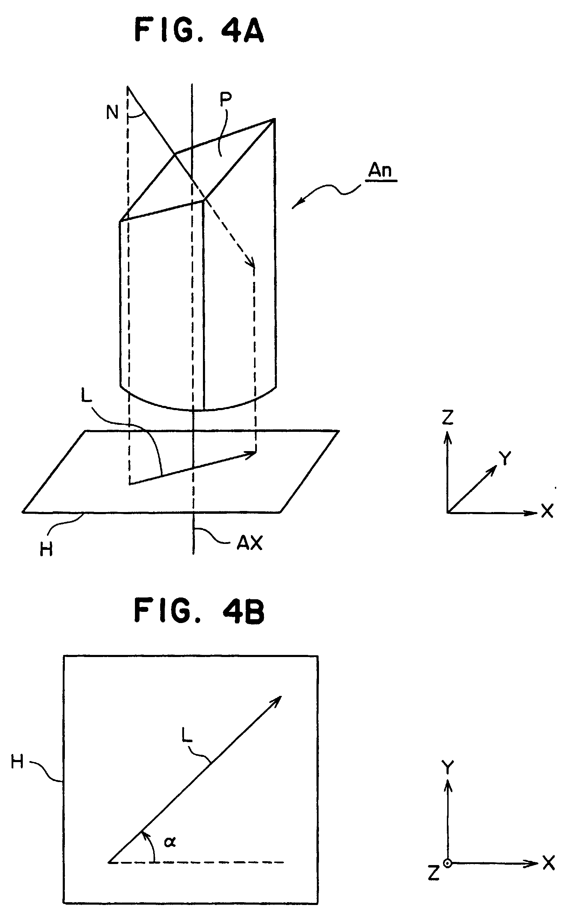

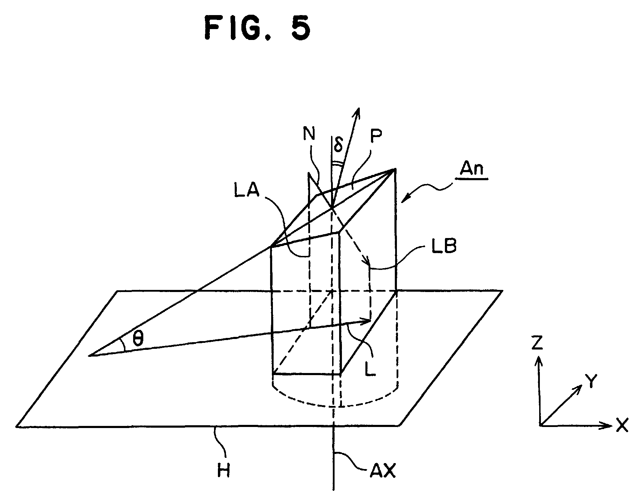

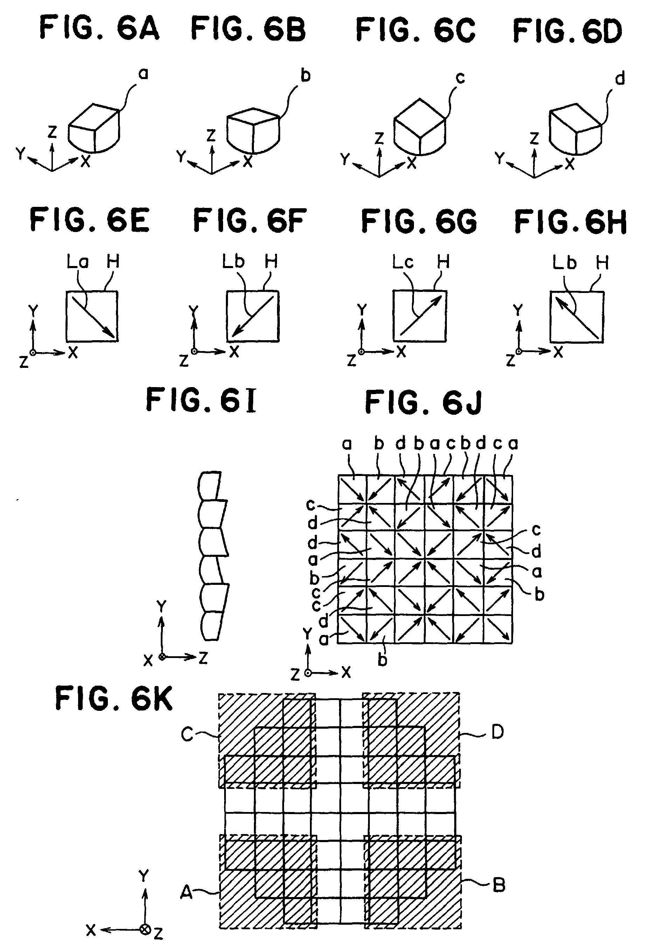

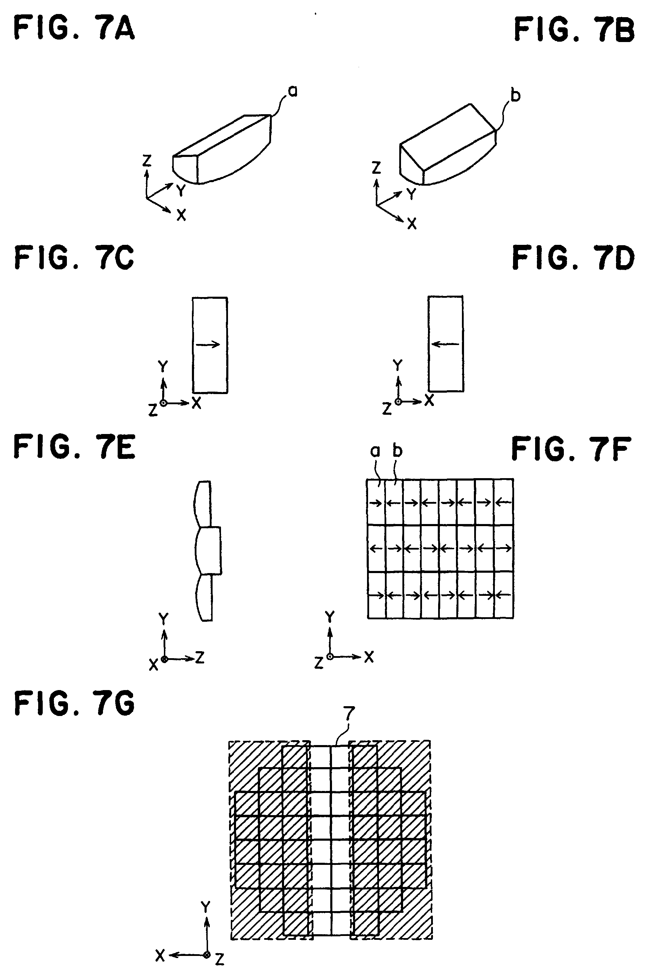

A projection exposure apparatus in a first embodiment of the present invention will be explained referring to FIGS. 1 through 7G. FIG. 1 is a view showing an optical system of the projection exposure apparatus in the first embodiment of the present invention. FIGS. 2A and 2B are views showing layouts of a wavefront division type optical integrator and of an aperture stop. FIGS. 3A - 3D are views each illustrating a configuration of a fly's eye lens serving as the wavefront division type optical integrator. FIG. 3E is a diagram showing an illumination area on a second fly's eye lens based on the fly's eye lens shown in FIGS. 3A - 3D. FIGS. 4A, 4B and 5 are explanatory view showing an azimuth angle and a deviation angle of each of lens elements of the fly's eye lens. FIGS. 6A - 6J are views each showing a configuration of the fly's eye lens serving as the wavefront division type optical integrator in the first embodiment; FIG. 6K is a diagram showing an illumination area on a second fly's eye lens based on the fly's eye lens shown in FIGS. 6A - 6J. FIGS. 7A - 6F are views each showing a configuration of the fly's eye lens serving as the wavefront division type optical integrator in the first embodiment. FIG. 7G is a diagram showing an illumination area on a second fly's eye lens based on the fly's eye lens shown in FIGS. 7A - 7F.

Referring to FIG. 1, radiation beams emitted from a radiation source 1 composed of, e.g., an excimer laser travel through a beam profile adjusting optical system 2 including a beam expander and an anamorphic optical system, whereby a profile and a size of the radiation beams are adjusted to an arbitrary profile and size. The radiation beams from the beam profile adjusting optical system 2 are reflected by a mirror 3 and thereafter penetrate a quartz prism 4 for relieving polarization of the radiation beams. Note that this type of quartz prism 4 is described in depth in, e.g., Japanese Patent Application Laid-Open Publication Nos.3-16114 and 3-254114. The radiation beams from the quartz prism 4 arrive at a first fly's eye lens (a secondary radiation source forming element) as the wavefront division type optical integrator. In the first embodiment, a plurality of first fly's eye lenses different in type from each other are provided on a revolver 105 so provided as to be rotatable about a predetermined axis.

As shown in FIG. 2A, plural types of first fly's eye lenses 51 - 55 are provided, and one of these lenses is selectively positioned inside an illumination optical path by revolving the revolver 105. Herein, the first fly's eye lenses 51 - 53 have the same structure as the conventional fly's eye lens.

The structure of the first fly's eye lens 51 is explained referring to FIGS. 3A - 3K. The first fly's eye lens 51 is constructed in such a way that lens elements (unit optical system) 510 each taking a piano-convex shape as shown in a Y-Z side view in FIG. 3A and an X-Y plan view in FIG. 3B are integrated in a two-dimensional matrix as illustrated in a Y-Z side view in FIG. 3C and an X-Y plan view in FIG. 3D. In this case, the plurality of lens elements 510 converge the radiation beams incident upon the respective lens elements and form radiation source images outside the lens elements 510, wherein the radiation source images of which the number corresponds to the number of the lens elements 510 are formed by the first fly's eye lens as a whole. Note that the first fly's eye lens 52 provided on the revolver 105 shown in FIG. 2A has substantially the same configuration as the first fly's eye lens 51 described above and has a focal length longer than that of the first fly's eye lens 51. Further, the first fly's eye lens 53 also takes substantially the same configuration as the first fly's eye lens 51 described above and has a focal length longer than that of the first fly's eye lens 52.

In accordance with the first embodiment, the radiation source 1 involves the use of a laser, and hence an exit end surface of each of the lens elements configuring the first fly's eye lenses 51 - 53 is plane, however, this exit end surface is not limited to the plane surface. Note that the fly's eye lens structured so that the illuminant image forming positions are set outside the lens elements, is disclosed in, e.g., Japanese Patent Application Laid-Open Nos. 63-66553, 1-81222 and 2-48627.

Now, the radiation beams falling upon the first fly's eye lens, as discussed above, form the plurality of radiation source images (secondary radiation sources) on the radiation-exit side. The radiation beams diverging from the plurality of radiation source images are converged by a relay lens 6, and an incident surface of a second fly's eye lens 7 serving as a second optical integrator is uniformly illuminated with these converged radiation beams in a way of being overlapped with each other. In this case, an illumination region on the incident surface of the second fly's eye lens 7 is defined as shown by hatching in FIG. 3E, and therefore the entire incident surface of the second fly's eye lens 7 is illuminated with the radiation beams. As a result, a planar radiation source composed of a multiplicity of tertiary radiation source images of which the number corresponds to a product of the number of the lens elements of the first fly's eye lens and the number of the lens elements of the second fly's eye lens, is formed on an exit surface of the second fly's eye lens 7. An aperture stop for changing a shape of the planar radiation source into a desired shape by restricting the profile of the radiation beams passing therethrough, is provided in the vicinity of a position where the planar radiation source is formed on the second fly's eye lens 7.

As shown in FIG. 2B, in the first embodiment, plural types of aperture stops 81 - 85 having aperture configurations different from each other are provided on a revolver 108 rotatable about a predetermined axis, one of these aperture stops is selectively positioned within an illumination optical path by revolving the revolver 108.

Referring back to FIG. 1, the radiation beams passing through the aperture stop are guided via condenser lens units 9 and 11 to a reticle (mask) 13, positioned at a surface to be illuminated, on which a predetermined circuit pattern (device pattern) is depicted. Herein, a field stop 10 for defining an illumination area (illumination region) on the reticle 13 is disposed in the condenser lens units 9, 11. The condenser lens units 9, 11 are, it may be conceived, separated into a lens system 9 for converging the radiation beams through the aperture stops and uniformly illuminating the field stop 10 with the converged radiation beams in a way of being overlapped with each other, and into a field stop projection optical system 11 for uniformly illuminating the illumination area on the reticle 13 by forming an image of the illuminated field stop 10 onto the reticle 13.

Then, a pattern formed on the reticle 13 by the radiation beams with which to uniformly illuminate the field stop 10, is projected through a projection lens 14 on a wafer (workpiece) 15 defined as an object to be exposed, thus exposing the wafer 15 to the radiation of this pattern. Note that the reticle 13 is held on a reticle stage MST so provided as to be movable within the X-Z plane in FIG. 1 and rotatable about the Y-axis, and the wafer 15 is held on a wafer stage WST so provided as to be movable in the XYZ-direction in FIG. 1 and adjustable of its inclination to the Y-axis.

Before touching on a configuration of a first fly's eye lens 55, a direction and a quantity of an inclination of the exit surface of each lens element will be explained referring to FIGS. 4A, 4B and 5. FIGS. 4A and 4B are an explanatory view and an explanatory diagram showing the direction of the inclination of the exit surface. For simplicity, an optical axis AX of the illumination optical system is set coincident with an optical axis of a lens element An. An exit surface P of the lens element An is inclined to a predetermined plane H perpendicular to the optical axis AX of the illumination optical system. Then, presuming a straight line (which will hereinafter be called an [azimuth straight line]) L into which a normal line N of the exit surface P is projected on the predetermined plane H, as shown in FIG. 4B, an angle made by the azimuth straight line and the X-axis is set as an azimuth angle $\alpha$. The azimuth angle $\alpha$ corresponds to a direction in which the radiation beam of incidence is deflected by the lens element.

FIG. 5 is an explanatory view showing a quantity of inclination of the exit surface. Herein also, for simplicity, the optical axis AX of the illumination optical system is set coincident with the optical axis of the lens element An. Within the plane including the azimuth straight line L and a straight line LA or LB parallel to the optical axis AX, an angle made by the exit surface P of the lens element An and by the predetermined plane H is set as an apex angle $\theta$ of the lens element An, when this apex angle $\theta$ and a refractive index n of the lens element An are determined, a deflection angle $\delta$ defined as a quantity with which the incident radiation beam is deflected by the lens element, can be obtained. At this time, the apex angle $\theta$ if the lens element An and the deviation angle $\delta$ have the following relation.

$$n \cdot \sin\theta = \sin(\theta + \delta) \qquad (1)$$

In fact, a distribution of the illumination area on the incident surface of the second fly's eye lens is a given value, and the deviation angle $\delta$ for obtaining the distribution is determined ahead. Such being the case, the above formula (1) is transformed such as:

$$\tan\theta = (\sin\delta) / (n - \cos\delta) \qquad (2)$$

The apex angle $\theta$ of the lens element An can be obtained from the given deviation angle $\delta$.

Referring next to FIGS. 6A - 6K, the first fly's eye lens 55 in the first embodiment will be described. The first fly's eye lens 55 is constructed such that the plurality of lens elements, i.e., plano-convex lenses, of which exit surfaces (flat surfaces) are inclined with predetermined quantities in predetermined directions, are integrated in the two-dimensional matrix.

The first fly's eye lens 55 in the first embodiment has four types of lens elements (unit optical systems) such as a lens element a shown in FIG. 6A, a lens element b shown in FIG. 6B, a lens element c shown in FIG. 6C, and a lens element d shown in FIG. 6D. Herein, as shown in FIGS. 6E - 6H, azimuth straight lines La - Ld of the respective lens elements on the predetermined plane H, are in directions rotating through 90 degrees with respect to each other. Then, those four types of lens elements a - d are assembled in a checkered pattern as shown in FIGS. 6I and 6J. Note that FIG. 6I is a YZ plan view of the first fly's eye lens 55, and FIG. 6J is an XY plan view. As understood from FIG. 6J, the first fly's eye lens 55 includes a plurality of lens element units each consisting of four pieces of lens elements each having an angle of 90 degrees made by their azimuth straight lines.

Note that the respective lens elements a - d of the first fly's eye lens 55 shown in FIGS. 6A - 6D have each a focal length that is more than twice the focal length of each of the lens elements 510 of the first fly's eye lens shown in FIG. 3A and so on. Further, the deviation angles $\delta$ of the lens elements a - d of the first fly's eye lens 55 are set to the same numerical value.

Thus, the lens elements a - d constituting the first fly's eye lens 55 in the first embodiment are eccentrically arranged so that the radiation beam incident along a central axis (an optical axis of the lens element) connecting the center of an incidence-side clear aperture diameter of the lens element to the center of an exit-side clear aperture diameter thereof, exits with an inclination to this central axis. Therefore, as shown in FIG. 6K, not a central part but positions shifted sideways on the incident surface of the second fly's eye lens 7 are illuminated with the radiation beams traveling through the lens elements.

At this time, the relay optical system 6 illuminates an area A with the radiation beams deflected by the plurality of lens elements a in the way of being overlapped with each other. The relay optical system 6 illuminates an area B with the radiation beams deflected by the plurality of lens elements b in the way of being overlapped with each other. The relay optical system 6 illuminates an area C with the radiation beams deflected by the plurality of lens elements c in the way of being overlapped with each other. The relay optical system 6 illuminates an area D with the radiation beams deflected by the plurality of lens elements d in the way of being overlapped with each other. Namely, the area A may be conceived as what the radiation beams penetrating the plurality of lens elements a are overlapped with each other. The area B may be conceived as what the radiation beams penetrating the plurality of lens elements b are overlapped with each other. The area C may be conceived as what the radiation beams penetrating the plurality of lens elements c are overlapped with each other. The area D may be conceived as what the radiation beams penetrating the plurality of lens elements d are overlapped with each other. Accordingly, it is feasible to maintain a characteristic of a double fly's eye lens system. The characteristic is a characteristic that the radiation beams with a divided wavefront are overlapped with each other on the incident surface of the second fly's eye lens. This characteristic may embrace, to be specific, an effect (1) that an illuminance of the illumination radiation can be uniformized by increasing the number of wavefront divisions without any increase in manufacturing costs, an effect (2) that an adverse influence caused by vibrations of the radiation beams from the radiation source can be prevented, and an effect (3) that a quantity of decline of the illuminance uniformity in the case of changing the configuration of the aperture stop, is small (a quantity of change from an ideal Köhler illumination state is small).

Herein, if an aperture stop 85 having four apertures shown in FIG. 2B is disposed on the exit surface of the second fly's eye lens 7, it is obvious that a loss of the radiation quantity in the case of using the first fly's eye lens 55 is smaller than by using the conventional first fly's eye lens 51.

Note that the direction of deviating sideways and the deviation quantity on the incident surface of the second fly's eye lens 7 are determined by the direction and quantity (deviation angle δ) of the eccentricity of each lens element. In the first embodiment, the eccentricity of each of the lens elements is set in the four directions, and the deviation angles δ thereof are all set to the same numerical value, however, the eccentric direction is not limited to the four directions, and the deflection angle δ is not confined to the same numerical value.

Further, in the first embodiment, the lens elements are arranged in the checkered pattern and may also be arranged in any patterns. If the lens elements constituting the second fly's eye lens 7 have a large aberration, however, it is desirable that a whole image configuration of the plurality of radiation source images formed through the first fly's eye lens on the respective exit surfaces of the lens elements of the second fly's eye lens 7, be symmetric in rotation to the greatest possible degree in order to reduce an influence of the aberration.

In the first embodiment, for example, only the radiation beams passing through the lens elements a of the first fly's eye lens 55 are guided to the lens elements of the second fly's eye lens disposed within the area A in FIG. 6K. Accordingly, the image configuration of the plurality of radiation source images formed on the exit surface of one single lens element disposed within the area A, corresponds to a position of the lens element a of the first fly's eye lens 55. Therefore, in order to form the image taking the rotationally symmetric configuration on the exit surface of each of the lens elements of the second fly's eye lens 7 disposed within the area A, it is understood that the plurality of lens elements a of the first fly's eye lens 55 may be disposed in the rotation symmetry.

The same discussion may be established with respect to the lens elements of the second fly's eye lens disposed with in each of other areas B, C and D, and hence the lens elements a ~ d are, as shown in FIG. 6J, disposed so as to get proximal to rotationally symmetric positions in the first embodiment.

Referring next to FIGS. 7A - 7G. a first fly's eye lens 54 in the first embodiment will be explained, this first fly's eye lens 54 is likewise structured such that the lens elements. i.e., the piano-convex lenses of which the exit surfaces (flat surfaces) are inclined with predetermined quantities in predetermined directions, are integrated in the two-dimensional matrix.

The first fly's eye lens 54 in the first embodiment has two types of lens elements (unit optical systems) such as a lens element a shown in FIG. 7A, and a lens element b shown in FIG. 7B. Herein, as shown in FIGS. 7C and 7D, azimuth straight lines La and Lb of the respective lens elements on the predetermined plane H, are in directions rotating through 180 degrees with respect to each other. Then, those two types of lens elements a, b are assembled in a checkered pattern as shown in FIGS. 7E and 7F. Note that FIG. 7E is a YZ plan view of the first fly's eye lens 54, and FIG. 7F is an XY plan view. As understood from FIG. 7F, the first fly's eye lens 54 includes a plurality of lens element units each consisting of two pieces of lens elements each having an angle of 180 degrees made by their azimuth straight lines. Note that the deviation angles δ of the lens elements a, b of the first fly's eye lens 54 are set to the same numerical value. The lens elements a, b constituting the first fly's eye lens 54 in the first embodiment are also eccentrically arranged so that the radiation beam incident along a central axis (an optical axis of the lens element) connecting the center of an incidence-side clear aperture diameter of the lens element to the center of an exit-side clear aperture diameter thereof, exits with an inclination to this central axis. Therefore, as shown in FIG. 7G. not a central part but positions shifted sideways on the incident surface of the second fly's eye lens 7 are illuminated with the radiation beams traveling through the lens elements.

At this time, the relay optical system 6 illuminates the area A with the radiation beams deflected by the plurality of lens elements a in the way of being overlapped with each other. The relay optical system 6 illuminates the area B with the radiation beams deflected by the plurality of lens elements b in the way of being overlapped with each other.

Herein, it is apparent that even in a case where an aperture stop 84 having two apertures shown in FG. 2B is disposed on the exit surface of the second fly's eye lens 7, an eclipse of the radiation beams and a loss of the radiation quantity in the case of using the first fly's eye lens 54, are smaller than by using the conventional first fly's eye lens 51.

Note that the direction of deviating sideways and the deviation quantity on the incident surface of the second fly's eye lens 7 are determined by the direction and quantity (deviation angle $\delta$ ) of the eccentricity of each lens element. In the first fly's eye lens 54, the eccentricity of each of the lens elements is set in the two directions, and the deviation angles $\delta$ thereof are all set to the same numerical value, however, the eccentric direction is not limited to the two directions, and the deviation angle $\delta$ is not confined to the same numerical value.

Next, an operation of switching over the first fly's eye lenses 51 - 55 and an operation of switching over the aperture stops 81 - 85, will be explained referring to FIGS. 1, 2A and 2B.

Referring to FIG. 1, a drive unit MT1 having a motor or an air cylinder etc rotationally drives the revolver 105 provided with the plural types of first fly's eye lenses 51 - 55, whereby one of the first fly's eye lenses 51 - 55 is positioned within the optical path. Then, a drive unit MT2 having the motor or the air cylinder etc rotationally drives the revolver 108 provided with the plural types of aperture stops 81 - 85, whereby one of the aperture stops 81 - 85 is positioned within the optical path. Further, a variable aperture stop 114 capable of making an aperture diameter variable is disposed in the vicinity of a pupil position of the projection lens 14. A drive unit MT3 drives the variable aperture stop 114 so that the aperture diameter thereof is set to a predetermined diameter. Note that the variable aperture stop 114 bears substantially a conjugate positional relation with the aperture stops 81 - 85. Those drive units MT1 - MT3 are connected to a main control unit 100 to receive control signals from the main control unit 100.

Further, the exposure apparatus in the first embodiment is provided with a reticle stocker RS for stocking plural types of reticles. A barcode reader BR for reading a barcode pattern BC formed on a reticle 13 is provided in a reticle carry path extending from the reticle stocker RS down to a reticle stage MST. The barcode reader BR is connected to the main control unit 100 so that read data of this barcode pattern BC can be transferred to the main control unit 100.

Moreover, an input unit 101 including a keyboard etc. is connected to the main control unit 100, and an input signal from the input unit 101 is thereby transmitted to the main control unit 100. Note that the input unit 101 may be an interface provided in a device manufacturing factory and connected via LAN (Local Area Network) to a host computer for controlling device manufacturing apparatuses such as a plurality of exposure apparatuses etc, this interface serving to receive control signals from this host computer.

Now, when a signal relative to an indication of exchanging the reticle is transmitted from the input unit 101 to the main control unit 100, the main control unit 100 commands an unillustrated robot arm etc to take out a predetermined reticle 13 from within the reticle stocker RS, and the reticle is carried along the carry path described above and placed on the reticle stage MST. At this time, the barcode reader BR transfers the data of the barcode pattern formed on the reticle 13 to the main control unit 100. Herein, the barcode pattern on the reticle 13 is stored with pieces of data on illumination conditions including data about the types of the aperture stops 81 - 85 and data about an aperture diameter of the variable aperture stop 114. The main control unit 100 controls, based on the illumination conditions, the driving of the drive units MT1 - MT3.

Note that the data contained in the barcode pattern on the reticle 13 may not have the data on the illumination conditions. In this case, a reticle name retained in the barcode pattern and the illumination conditions corresponding to this reticle name are stored in or inputted beforehand to the main control unit 100. The data about the reticle name read by the barcode reader BR are collated with the data on the illumination conditions stored therein, and the driving of the drive units MT1 - MT3 is controlled based on data about the illumination conditions collated therewith. Further, in this instance, the data about the name of the reticle to be used and the data on the illumination conditions at that time may be inputted directly from the input unit 101 without using the barcode reader BR.

Referring to FIGS. 2A and 2B, the following is one example of correspondence relations between the aperture stops 81 - 85 and the first fly's eye lenses 51 - 55 in the first embodiment.

When the aperture stop 81 having a large diameter (which may be referred to as a large $\sigma$ illumination-oriented aperture stop) is selected as an aperture stop, the first fly's eye lens 51 having a short focal length that is the same as the conventional fly's eye lens (for its configuration, see FIGS 3A - 3D) is selected. Further, when the aperture stop 82 having an intermediate diameter (which may be referred to as an intermediate $\sigma$ illumination-oriented aperture stop) is selected as an aperture stop, the first fly's eye lens 52 having an intermediate focal length is selected. Moreover, when the aperture stop 83 having a small diameter (which may be referred to as a small $\sigma$ illumination-oriented aperture stop) is selected as an aperture stop, the first fly's eye lens 53 having a large focal length is selected. When the aperture stop 84 having the two apertures is selected as an aperture stop, the above-described fly's eye lens 54 (for its configuration, see FIGS. 7A - 7F) is selected. When the aperture stop 85 for quadrupolar (4-aperture) illumination is selected as an aperture stop, the fly's eye lens 55 (for its configuration, see FIGS. 6A - 6J) described above is selected. In accordance with the first embodiment, the main control unit 100 controls the drive units MT1 and MT2 so as to have the correspondence relations given above.

The optimal illumination corresponding to the type of the reticle can be attained in a state of minimizing a loss of quantity of the illumination radiation, and both of a resolution and a throughput can be enhanced at the same time.

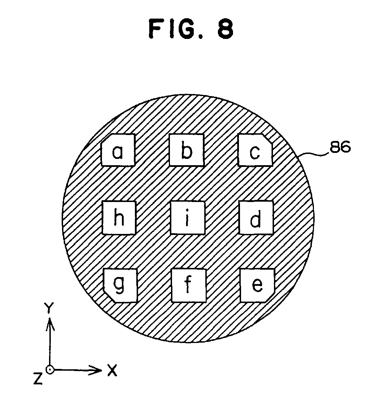

Next, an applied example (a modified example) of the first embodiment will be discussed with reference to FIG. 8 is an XY plan view showing a configuration of an aperture stop provided in the illumination optical system. An aperture stop 86 illustrated in FIG. 8 has a plurality (nine pieces) of apertures a - i arranged in a square matrix. Herein, the aperture i among the plurality of apertures is disposed in a position including an optical axis of an illumination optical system when this aperture stop 86 is positioned within the optical path of the illumination optical system. Then, the apertures a, e are formed in eccentric positions substantially at an equal distance with the optical axis being centered therebetween, and the apertures c, g are formed in eccentric positions substantially at an equal distance with the optical axis being centered therebetween. A straight line connecting a couple of the apertures a, e and a straight line connecting another couple of the apertures c, g, are substantially orthogonal to each other. Further, the apertures b, f are formed in eccentric positions substantially at an equal distance with the optical axis being centered therebetween, and the apertures d, h are formed in eccentric positions substantially at an equal distance with the optical axis being centered therebetween. A straight line connecting a couple of apertures b, f and a straight line connecting another couple of apertures d, h, are substantially orthogonal to each other. Furthermore, the straight line connecting the couple of apertures a, e and the straight line connecting the couple of apertures c, g, intersect each other substantially at 45 degrees on the XY plane. The straight line connecting the couple of apertures b, f and the straight line connecting the couple of apertures d, h, intersect each other substantially at 45 degrees on the XY plane.

In the case of using the aperture stop 86 having the plurality of apertures a - i described above, when the first fly's eye lens illuminates the second fly's eye lens with the radiation beams, it is set how many beams among the radiation beams split at the first fly's eye lens are allocated from the aperture a to the aperture i, thereby making it feasible to arbitrarily determine an intensity ratio between the illumination radiation beams with which the respective apertures a - i are illuminated.

For example, if the radiation intensities are allocated to only the apertures a, c, e, g among the nine apertures of the aperture stop 86, the general 4-aperture illumination can be carried out. If allocated to only the apertures h, d, the general 2-aperture illumination can be performed. If allocated to the apertures a, b, c, d, e, f, g, h (if allocated to all the apertures excluding the aperture i), an annular illumination can be conducted in a pseudo manner. If the radiation intensities are allocated evenly to all the apertures a - i, the illumination through a normal circular aperture can be attained in the pseudo manner. When the thus constructed aperture stop 86 is provided in the illumination apparatus, the variety of illuminations can be attained simply by selectively switching over the type of the first fly's eye lens with the revolver 105 without replacing the aperture stop 86 with a different aperture stop.

Note that a mode of allocating the intensities of the illumination radiation through the first fly's eye lens is not limited to the allocation mode described above in this case. For instance, when allocating the illumination radiation beams to the apertures a, b, c, d, e, e, g, h, the illumination radiation beams with a lower intensity than to these apertures may be allocated to the aperture i, and may also be allocated with a predetermined intensity difference between a group of the apertures a, c, e, g and a group of the apertures b, a, f, g.

Further, in a state where the aperture stop 81 (the large σ illumination-oriented aperture stop) having the largest aperture diameter shown in FIG. 2B remains set in the illumination optical path, the first fly's eye lenses 51 - 55 may be exchanged. In this case, an illuminance distribution within the aperture of the aperture stop 81 can be changed only by changing the first fly's eye lens, and substantially the same effect as the effect yielded when changing the type of the aperture stop, can be attained. In this instance, if the relay optical system 6 for leading the radiation beams from the first fly's eye lenses 51 - 55 to the second fly's eye lens is composed of a zoom lens, a size of the planar radiation source formed by the second fly's eye lens serving as an auxiliary optical integrator, can be changed. Further, a distance, from the optical axis, of the eccentric planar radiation source when performing the bipolar or quadrupolar illumination, can be consecutively changed.

Note that the aperture stop and the first fly's eye lens are replaced by the turret method in the embodiment discussed above and may also be replaced by, instead of this method, a slider method disclosed in, e.g., Japanese Patent Application Laid-Open No.6-204114 etc. The slider method might, however, easily bring about an adverse influence caused by a deviation in position of center of gravity of the apparatus due to the replacing operation, and therefore the revolver (turret) method is more preferable. A further construction may be taken, wherein the variable aperture stop capable of consecutively changing the aperture diameter is provided as an aperture stop existing in the illumination apparatus, and there is provided a shield member (a center shield, a band shield or a cross shield) detachably attached in a position vicinal to the variable aperture stop.

Now, when assembling the optical system including the double fly's eye lenses described above, it is preferable that the second fly's eye lens visible from the aperture of the aperture stop of the illumination apparatus be illuminated with the radiation beams in a way of its being circumscribed with an outer portion thereof. In other words, when the radiation beams split by the first fly's eye lens are overlapped with each other at a plurality of spots on the incident surface of the second fly's eye lens, it is preferable that the lens elements (which are overlapped with the aperture areas among the plurality of lens elements of the second fly's eye lens) of the effective second fly's eye lens, be embraced so as not to extrude from this overlapped area. As discussed above, for establishing the double fly's eye lens system, the radiation beams, which are wavefront-divided by the first fly's eye lens and overlapped, must be put into the overlapped state by effecting again the wavefront-division with the second fly's eye lens. If there exists such a lens element that the radiation beams fall on only the half of the clear aperture diameter thereof among the effective lens elements of the second fly's eye lens, however, it follows that the radiation beams of which only the half enters are overlapped on the surface to be illuminated, with the result that the advantage of the double fly's eye lens system discussed above can not be obtained. This phenomenon is not therefore preferable.

(Second Embodiment)

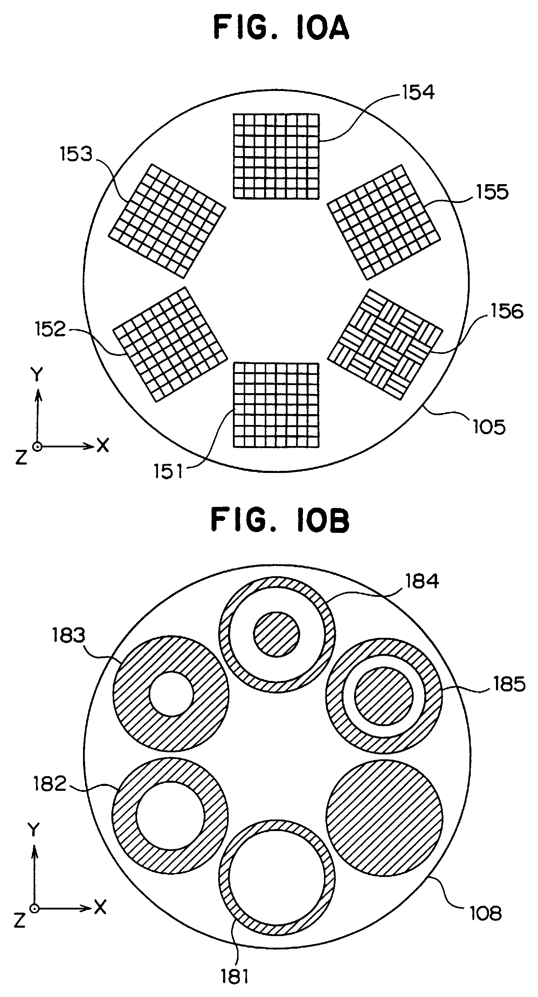

Next, the projection exposure apparatus in accordance with a second embodiment will be described. As discussed above, in the optical system of the exposure apparatus in the first embodiment, when the radiation beams are incident upon the second fly's eye lens, if there exists the lens element that the radiation beams fall on only the half of the clear aperture diameter thereof among the effective lens elements of the second fly's eye lens, especially the lens element where the illumination area changes stepwise on the incident surface, the uniformity of the illuminance on an exposed surface 15 might decline. It is therefore more preferable that the illuminance distribution changed stepwise due to the deviation of the radiation beams with the divided wavefront be changed gently by providing a radiation diffusion member at a radiation-source-sided portion of the first fly's eye lens. Herein, it is preferable that the radiation diffusion member be such a lemon skin filter that ruggedness of an obscure glass thereof is smoothed.
In the second embodiment, for the reason elucidated above, the lemon skin filter LS as the radiation diffusion member is disposed at the radiation-source-sided portion of the first fly's eye lens. The basic configuration other than the lemon skin filter LS is the same as that of the projection exposure apparatus in the first embodiment. Note that the radiation diffusion member involves the use of the lemon skin filter LS in the second embodiment, and hence there is not kept the state that "the radiation beams wavefront-divided and overlapped are again wavefront-divided and overlapped" as the characteristic of the double fly's eye lens optical system. Accordingly, this system has the same effect as the single fly's eye lens optical system has.

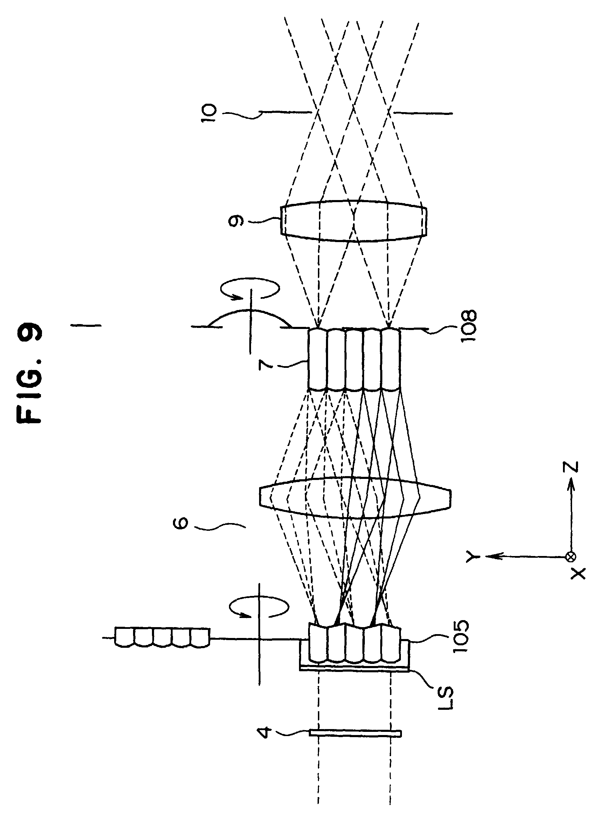

FIG. 9 is a view showing an optical system of the fly's eye lens unit of the projection exposure apparatus in the second embodiment of the present invention. The components excluding the optical system shown in FIG. 9 are the same as those of the exposure apparatus in the first embodiment shown in FIG. 1, of which repetitive explanations are omitted, and are marked with the same numerals in FIG. 1.
As in the case of the apparatus in FIG. 1, the radiation beams emitted from the radiation source such as the excimer laser travel through the beam profile adjusting optical system 2, wherein the profile of the radiation beams is adjusted to an arbitrary profile. Thereafter, these radiation beams are incident on the lemon skin filter LS via the mirror 3 and the quartz prism 4 for relieving the polarization of the radiation-beams.
Then, the radiation beams diffused by the lemon skin filter LS enter any one of first fly's eye lenses 151 - 156 each composed of a plurality of optical elements, and secondary radiation sources consisting of a multiplicity of radiation source images are formed on its exit surface. The radiation beams diverging from the multiplicity of secondary radiation sources are converged by the relay lens 6, and the incident surface of the second fly's eye lens 7 is uniformly illuminated with these converged radiation beams in the way of being overlapped with each other.
As a result, the multiplicity of radiation source images (tertiary radiation sources), of which the number corresponds to a product of the number of the lens elements of the first fly's eye lens and the number of the lens elements of the second fly's eye lens, can be formed on the exit surface of the second fly's eye lens 7. Next, a diameter of the radiation beams diverging from the planar radiation source as the tertiary radiation sources is restricted by any one of aperture stops 181 - 185, and these radiation beams are thereafter guided to the condenser lens groups 9, 11. Then, a reticle or mask 13 depicted with a pattern subjected to a projection exposure is uniformly illuminated with these radiation beams in the way of being overlapped with each other. Herein, a field stop 10 for defining an illumination region is disposed in the condenser lens groups 9, 11. The pattern formed on the reticle or mask 13 uniformly illuminated with the illumination radiation beams is projected on an object 15 to be exposed, thus exposing this object 15 to the radiation of the reticle or mask pattern.
Herein, in accordance with the second embodiment, as shown in FIG. 10A, as in the first embodiment, the plurality of first fly's eye lenses 151 - 156 are attached to the rotatable revolver 105, and the plurality of aperture stops 181 - 185 are attached to the rotatable revolver 108. Note that the drive unit for driving these revolvers, the main control unit for controlling this drive unit and the input unit such as the barcode reader etc for inputting the illumination conditions to the main control unit, are the same as those in the first embodiment discussed above, and therefore their repetitive explanations are herein omitted.

Herein, the first fly's eye lens 151 among the first fly's eye lenses 151 - 156 provided on the revolver 105 is equivalent to the first fly's eye lens 51 in the first embodiment, the first fly's eye lens 152 is equivalent to the first fly's eye lens 52 in the first embodiment, and the first fly's eye lens 153 is equivalent to the first fly's eye lens 53 in the first embodiment. Further, the aperture stop 181 among the aperture stops 181 - 185 provided on the revolver 108 is equivalent to the aperture stop 81 in the first embodiment, the aperture stop 182 is equivalent to the aperture stop 82 in the first embodiment, and the aperture stop 183 is equivalent to the aperture stop 83 in the first embodiment.

Next, a configuration of the first fly's eye lens 154 in the second embodiment will be explained with reference to FIGS. 11A - 11D. The first fly's eye lens 154 is constructed of a plurality of lens elements, and each lens element An has, as shown in FIG. 11A, a convex lens surface and a flat surface inclined to an optical axis of the lens element. Note that the optical axis of the lens element indicates a central axis connecting a center of an incidence-side clear aperture diameter of the lens element to a center of an exit-side clear aperture diameter thereof.

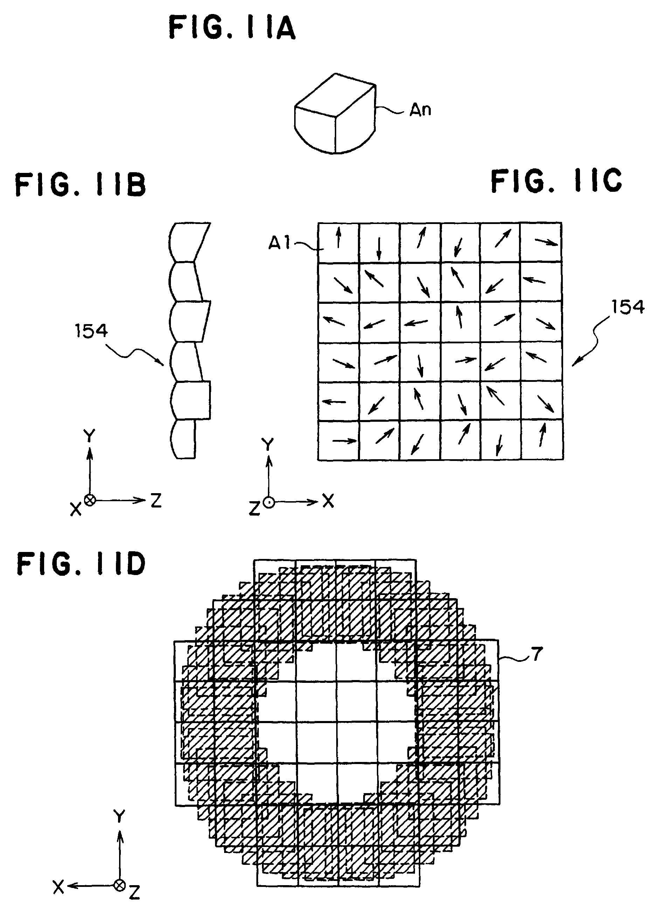

In the second embodiment, a plurality (36 pieces in the second embodiment) of lens elements A1 - A36 have each the same apex angle $\theta$, however azimuth straight lines thereof are different by $10°$ from each other. FIG. 11B is a YZ plan view of the first fly's eye lens 151. FIG. 11C is an XY plan view of the first fly's eye lens. As shown in FIGS. 11B and 11C, the lens elements A1 - A36 having the azimuth straight lines different by $10°$ from each other are integrated in the two-dimensional matrix, thereby forming the first fly's eye lens 154. It is to be noted that a focal length of each of the lens elements A1 - A36 is longer than, i.e., more than twice a focal length of each of the lens elements constituting the first fly's eye lens 151.

FIG. 11D is an XY plan view showing an illumination region on the incident surface of the second fly's eye lens 7 of the radiation beams via the first fly's eye lens 154. Note that FIG. 11D shows a case in which the lemon skin filter LS as the radiation diffusion member is not used.

The first fly's eye lens 154 takes a configuration in which each of the lens elements A1 - A36 constituting the first fly's eye lens 154 is eccentric so that the radiation beam incident along the optical axis of the lens element exits with a skew to this optical axis. Therefore, not a central part but positions shifted sideways on the incident surface of the second fly's eye lens 7 are illuminated with the radiation beams passing through these lens elements A1 - A36. Accordingly, the illumination by the radiation beams assumes an annular shape as shown by hatching in FIG. 11D.

Then, presuming that the aperture stop 185 shown in FIG. 10B is disposed on the side of the exit surface of the second fly's eye lens 7, it can be understood that a loss of the radiation quantity becomes smaller than by using the first fly's eye lens 151 having the same structure as the conventional one (see FIG. 3A etc).

Note that the direction in which the radiation beam deviates sideways and the deviation quantity are determined by the direction and quantity of the eccentricity of the lens element. The fly's eye lens 154 shown in FIGS. 11A and 11B involves the use of the lens elements having the same apex angle (the eccentric quantity) and eccentric in the variety of directions (the azimuth straight lines), and hence the annular shaped illumination can be attained. Incidentally, in the layout shown in FIG. 11C, the lens elements proximal in terms of the directions of the azimuth straight lines are disposed apart from each other as much as possible, and may also be arranged in many forms whatever. As in the first embodiment, however, if the lens elements constituting the second fly's eye lens have a large aberration, it is desirable that a whole image configuration of the plurality of illuminant images formed through the first fly's eye lens on the respective exit surfaces of the lens elements of the second fly's eye lens, be approximate to a rotation symmetry in order to reduce an influence of the aberration.

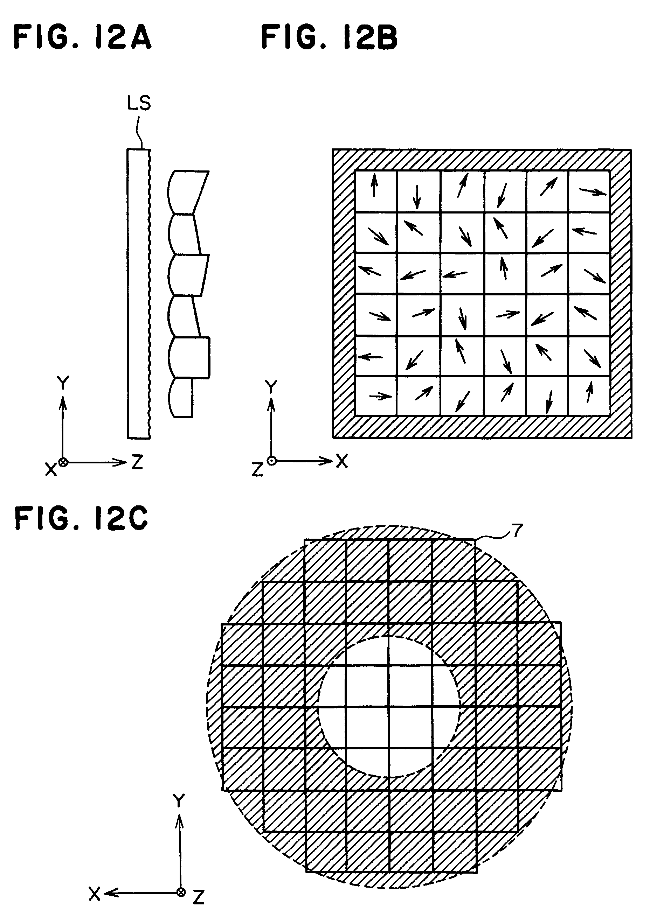

As shown in FIG. 11D, the illuminance distribution on the incident surface of the second fly's eye lens 7 changes stepwise. If remaining as it is, the uniformity of the illuminance on the surface 15 to be exposed might be lost. Therefore, in the second embodiment, as shown in FIGS. 12A and 12B, the lemon skin filter LS serving as the radiation diffusion member is provided on the incident side (on the side of the radiation source 1) of the first fly's eye lens 154, thereby diffusing the radiathon beams entering the first fly's eye lens. Note that FIG. 12A is a YZ plan view showing the first fly's eye lens 154 and the lemon skin filter LS, and FIG. 12B is an XY plan view thereof. Incidentally, as illustrated in FIG. 12B, the lemon skin filter LS has a size enough to cover the whole of the first fly's eye lens 154.

As obvious from the XY plan view showing the incident surface of the second fly's eye lens 7 in FIG. 12C, the illuminance distribution on the incident surface of the second fly's eye lens 7 becomes gentle as indicated by hatching in the Figure by providing the lemon skin filter LS.

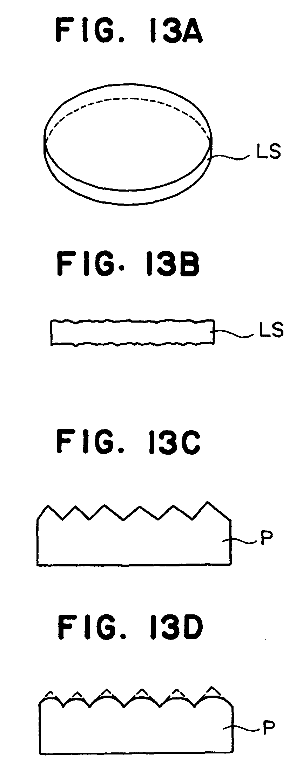

Next, this lemon skin filter LS will be described with reference to FIGS. 13A - 13D. The lemon skin filter LS is, as shown in FIGS. 13A and 13B, formed in a circular (or rectangular) shape, and both of surfaces of this filter LS are matted surfaces subjected to lemon skin working. FIGS. 13C and 13D are views showing a procedure of manufacturing the lemon skin filter LS. A surface of a flat plate P is roughly ground and thereafter abrasive machined by use of an abrasive grain on the order of #700. Then, the roughly ground and sanded surface, as shown in FIG. 13C, comes to have a roughness on the order of 5 μm. Thereafter, the roughly ground surface is subjected to a chemical treatment by use of hydrofluoric acid, whereby the lemon skin filter LS having a multiplicity of minute spherical surfaces (minute curved surfaces) into which the ruggedness of the roughly ground surface is smoothed can be obtained. It is to be noted that FIGS. 13C and 13D show an example where the lemon skin filter is formed by working the one single surface of the flat plate P and may also be formed by working the two surfaces. The surface of the thus formed lemon skin filter LS functions as if innumerable hyperfine micro lenses are arranged on this surface. Accordingly, an optical image forming relation is completely lost due to the diffusive action by the lemon skin filter LS, and an overlapping effect (averaging effect) yielded by the diffused radiation beams traveling in random (arbitrary) directions, acts in a multiplied manner.

Herein, the surface roughness of the lemon skin filter LS is set to approximately 5 μm. The requirement may, however, be simply that the surface roughness is well large as compared with a wavelength of the illumination radiation but is not limited to 5 μm. Namely, the abrasive grain in the abrasive machining process is not confined to #700. Further, what is important is the structure having the innumerable micro lenses, and even the diffusion plate, which exhibits the same effect and may be treated as a lemon skin filter by receiving other chemical treatments, has the same radiation diffusion effect, and therefore the radiation diffusion member is not limited to the lemon skin filter.

Next, the first fly's eye lenses 155, 156 in the second embodiment will be explained. The first fly's eye lens 155 has substantially the same structure as the first fly's eye lens 154, however, a difference is that a focal length of each of the lens elements constituting the first fly's eye lens 155 is set a bit longer than that of the first fly's eye lens 154.

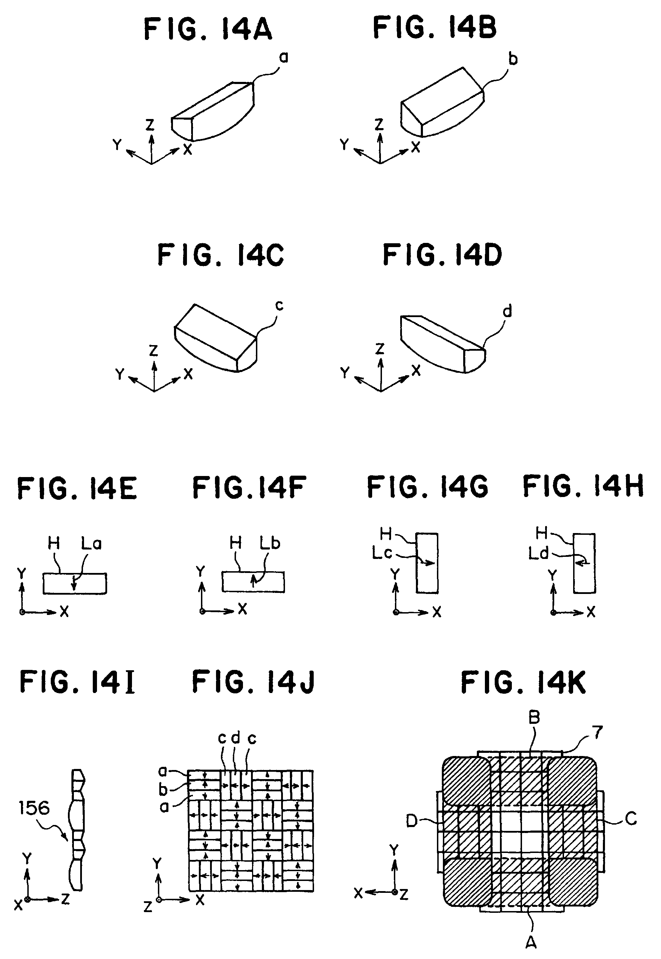

The first fly's eye lens 156 in the second embodiment includes four types of lens elements (unit optical systems) such as a lens element a shown in FIG. 14A, a lens element b shown in FIG. 14B, a lens element c shown in FIG. 14C, and a lens element d shown in FIG. 14D. Herein, as shown in FIGS. 14E - 14H, azimuth straight lines La - Ld of the respective lens elements on the predetermined plane H, are in directions rotating through 90 degrees with respect to each other. Then, the two types of lens elements a, b are assembled as shown in FIGS. 7I and 7. Note that FIG. 14I is a YZ plan view of the first fly's eye lens 156, and FIG. 14J is an XY plan view. Note that the deviation angles δ of the lens elements a - d of the first fly's eye lens 156 are set to the same numerical value.

The lens elements a - d constituting the first fly's eye lens 156 in the second embodiment are eccentrically arranged so that the radiation beam incident along a central axis (an optical axis of the lens element) connecting the center of an incidence-side clear aperture diameter of the lens element to the center of an exit-side clear aperture diameter thereof, exits with an inclination to this central axis. Therefore, as shown in FIG. 14K, not a central part but positions shifted sideways on the incident surface of the second fly's eye lens 7 are illuminated with the radiation beams traveling through the lens elements.

At this time, the relay optical system 6 illuminates an area A with the radiation beams deflected by the plurality of lens elements a in the way of being overlapped with each other. The relay optical system 6 illuminates an area B with the radiation beams deflected by the plurality of lens elements b in the way of being overlapped with each other. The relay optical system 6 illuminates an area C with the radiation beams deflected by the plurality of lens elements c in the way of being overlapped with each other. The relay optical system 6 illuminates an area D with the radiation beams deflected by the plurality of lens elements d in the way of being overlapped with each other. Accordingly, the radiation intensities higher than the radiation intensities in the areas A - D are shown in an overlapped region of the areas A and C, an overlapped region of the areas A and D, an overlapped region of the areas B and C, and an overlapped region of the areas B and D. In this case, a radiation intensity distribution of the planar radiation source formed on the exit-side of the second fly's eye lens 7 becomes what is intermediate between the annular configuration and the quadrupolar (4-aperture) configuration. Note that a technology of forming the planar radiation source having this intermediate radiation intensity distribution is disclosed in, e.g., Japanese Patent Application Laid-Open No.7-122478.

Incidentally, the focal lengths and the deflection angles (δ of the lens elements are all the same, but may not be limited to the same values. Further, the azimuth straight lines of the lens elements are set in the four directions, however, the number of the directions is not confined to 4.

Next, one example of correspondence relations between the first fly's eye lenses 151 - 156 and the aperture stops 181 - 184 will be explained.

When the aperture stop 181 having a large diameter (which may be referred to as a large σ illumination-oriented aperture stop) is selected as an aperture stop, the first fly's eye lens 151 having a short focal-length that is the same as the conventional fly's eye lens is selected. Further, when the aperture stop 182 having an intermediate diameter (which may be referred to as an intermediate σ illumination-oriented aperture stop) is selected as an aperture stop, the first fly's eye lens 152 having an intermediate focal length is selected. Moreover, when the aperture stop 183 having a small diameter (which may be referred to as a small σ illumination-oriented aperture stop) is selected as an aperture stop, the first fly's eye lens 153 having a large focal length is selected. When the aperture stop 184 including an annular shaped radiation transmitting area (a radiation shielding area is indicated by hatching in the Figure) is selected as an aperture stop, the fly's eye lens 154 is selected. When the aperture stop 185 having a different annular ratio (a ratio of an inside diameter to an outside diameter of the annular) from that of the aperture stop 184 is selected as an aperture stop, the first fly's eye lens 155 is selected. Then, the first fly's eye lens 156 is used in combination with the large σ illumination-oriented aperture stop 151. Note that the lemon skin filters LS as the radiation diffusion members are incorporated into the revolver 105 so as to be positioned on the respective incident surfaces of the first fly's eye lenses 154, 155 and 156, and switched over integrally with the first fly's eye lenses 154, 155, 156. Further, the first fly's eye lenses 154, 155 may be used in combination with the large σ illumination-oriented aperture stop 151.

In accordance with the second embodiment also, the unillustrated main control unit controls the drive units so as to have the correspondence relations given above. The optimal illumination corresponding to the type of the reticle can be thereby attained in a state of minimizing a loss of quantity of the illumination radiation, and both of a resolution and a throughput can be enhanced at the same time.

(Third Embodiment)

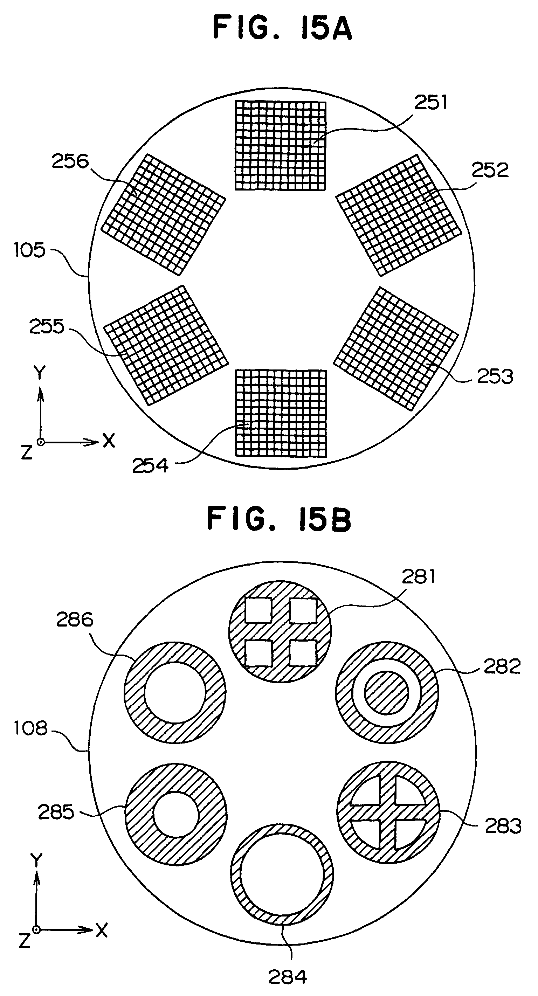

Next, a third embodiment will be discussed referring to FIGS. 15A - 17L. Note that the construction of the projection exposure apparatus in the third embodiment is almost the same as that projection exposure apparatus in the first embodiment illustrated in FIG. 1 except for configurations of the first fly's eye lens and of the aperture stop, and therefore the repetitive explanation of the whole projection exposure apparatus is omitted. The same components as those of the apparatus in FIG. 1 are marked with the same numerals.

In the third embodiment, a first fly's eye lens, into the wavefront division type optical integrator and a radiation deflection member are united, is constructed of a plurality of auxiliary optical member units each consisting of (4 x n) pieces of lens elements ((unit optical systems plus auxiliary optical members).

FIG. 15A is a view showing the revolver 105 provided with a plurality of first fly's eye lenses 251 - 256. FIG. 15B is a view showing the revolver 108 provided with a plurality of aperture stops 281 - 286.

As shown in FIG. 15A, in accordance with the third embodiment, the plurality of first fly's eye lenses 251 - 256 are attached onto the revolver 105, and any one of the plurality of first fly's eye lenses 251 - 256 is selectively positioned within the optical path of the illumination apparatus. Note that the plurality of first fly's eye lenses 251 - 256 are constructed so that illumination areas on the incident surface of the second fly's eye lens 7 are different from each other.

Further, as shown in FIG. 15B, the plurality of aperture stops 281 - 286 provided on the revolver 108 are constructed so that aperture configurations thereof are different from each other. The plurality of aperture stops 281 - 286 are provided on the revolver 108 so that any one of these stops 281 - 286 can be selectively positioned within the optical path of the optical system. In the third embodiment, these revolvers 105, 108 are, as in the first embodiment, rotationally driven by the drive units controlled by the main control unit of the projection exposure apparatus. One of the plurality of aperture stops 281 - 286 and one of the plurality of first fly's eye lenses 251 - 256 are thereby positioned within the optical path of the illumination apparatus, corresponding to the illumination conditions required.

Next, the first fly's eye lenses 251 - 256 will respectively explained. Herein, the first fly's eye lenses 251 - 256 are equivalent to the conventional fly's eye lenses. The first fly's eye lens 254 is equivalent to the first fly's eye lens 51 in the first embodiment, the first fly's eye lens 255 is equivalent to the first fly's eye lens 53 in the first embodiment, and the first fly's eye lens 256 is equivalent to the first fly's eye lens 52 in the first embodiment.

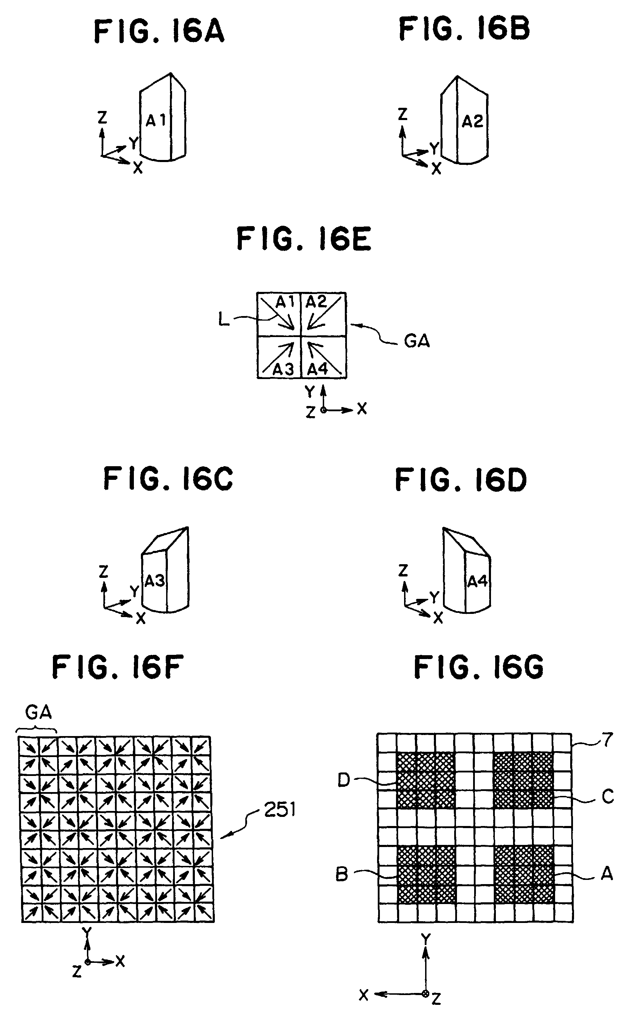

Then, the first fly's eye lens 251 is, based on the structure of the conventional fly's eye lens element of which the section (the YZ plane in the Figure) including the optical axis takes a plano-convex shape, classified as a fly's eye lens constructed by combining plano-convex lens elements A1 - A4 of which exit-side flat surfaces are, as shown in, e.g., FIGS. 16A - 16D, inclined to the optical axis.

Next, directions and quantities of the inclinations of the exit-side surfaces of the lens elements of the first fly's eye lens 251, will be described. Note that the direction of the azimuth straight line L, the apex angle θ, and the deviation angle δ of each of the lens elements which have been explained in FIGS. 4A, 4B and 5 are used in the following discussion.

As shown in FIGS. 16A - 16D, the four pieces of lens elements A1 - A4 of the first fly's eye lens 251 in the third embodiment, are formed so that their apex angles θ are equal to each other. Then, as illustrated in FIG. 16E, these lens elements A1 - A4 are integrated along the surface (the XY plane in the Figure) perpendicular to the optical axis so that angles made by the azimuth straight lines thereof are each 90 degrees. In the third embodiment, a group of the four lens elements A1 - A4 thus integrated is referred to as a lens element group GA (a group of the unit optical systems plus the auxiliary optical members). As illustrated in FIG. 16F, the first fly's eye lens 251 is constructed in such a way that a plurality of lens element groups GA are arrayed along the surface (the XY plane in the Figure) perpendicular to the optical axis.

The radiation beams exiting the first fly's eye lens 251 in the third embodiment are deflected in their optical paths by the exit surfaces, inclined to the optical axis, of the lens elements A1 - A4, and thereafter the four areas A - D on the incident surface of the second fly's eye lens 7 are, as shown in FIG. 16G. illuminated with these deflected radiation beams via the relay optical system 6.

In the third embodiment, the apex angles θ of the lens elements A1 - A4 constituting the first fly's eye lens 251 are all the same, and besides the angles made by the azimuth straight lines L are each 90 degrees (an azimuth angle α is ± 45 degrees, ± 135 degrees). Hence, the radiation beam incident along a central axis (an optical axis of the lens element) connecting the center of an incidence-side clear aperture diameter of the lens element to the center of an exit-side clear aperture diameter thereof, exits with an inclination, to this central axis of the lens element, by the deviation angle δ corresponding to the apex angle θ in a direction corresponding to the azimuth angle α. It therefore follows that not a central part but the areas A - D in four positions shifted sideways by a quantity corresponding to the deflection angle δ and the azimuth angle α (± 45 degrees, ± 135 degrees) on the incident surface of the second fly's eye lens, are illuminated with the radiation beams traveling through the lens elements.

The area A is illuminated with the radiation beams via the plurality of lens elements A1 in the way of being overlapped with each other. The area B is illuminated with the radiation beams via the plurality of lens elements A2 in the way of being overlapped with each other. The area C is illuminated with the radiation beams via the plurality of lens elements A3 in the way of-being overlapped with each other. The area D is illuminated with the radiation beams via the plurality of lens elements A4 in the way of being overlapped with each other. Thus, it is feasible to maintain the characteristic of the double fly's eye lens system, the radiation beams with a divided wavefront are overlapped with each other on the incident surface of the second fly's eye lens.

Herein, if a stop 281 having four rectangular apertures as shown in FIG. 15B is disposed on the exit surface of the second fly's eye lens, it is obvious that the loss of the radiation quantity in the case of using the first fly's eye lens 251 is smaller than by using the first fly's eye lens 254 equivalent to the conventional one.

Note that the lens element groups GA each taking the same rectangular shape are repeatedly arranged in the example shown in FIGS. 16A - 16G. however, the four lens elements within each lens element group GA may be arranged in any forms. If the lens elements constituting the second fly's eye lens 7 have a large aberration, however, it is desirable that the image of the first fly's eye lens that is formed on the exit surfaces of the lens elements of the second fly's eye lens 7, be symmetric in rotation to the greatest possible degree in order to reduce an influence of the aberration. For attaining this, it is preferable that an spatial distribution in which the lens elements occupy the positions on the first fly's eye lens 251, be symmetric in rotation about the types A1, A2, A3, A4 of all the lens elements.

Next, the first fly's eye lens 252 provided on the revolver 108 shown in FIG. 15A will be described. The first fly's eye lens 252 has such a configuration that the first fly's eye lens configured as what the wavefront division type optical integrator and the radiation deflection member are made integral, is constructed of a plurality of auxiliary optical member groups each consisting of (4 x n) pieces of lens elements (the unit optical systems plus the auxiliary optical members), the plurality of auxiliary optical member groups include first and second auxiliary optical member groups, and angles made by the azimuth straight lines of the first and second auxiliary optical members are set different therebetween.

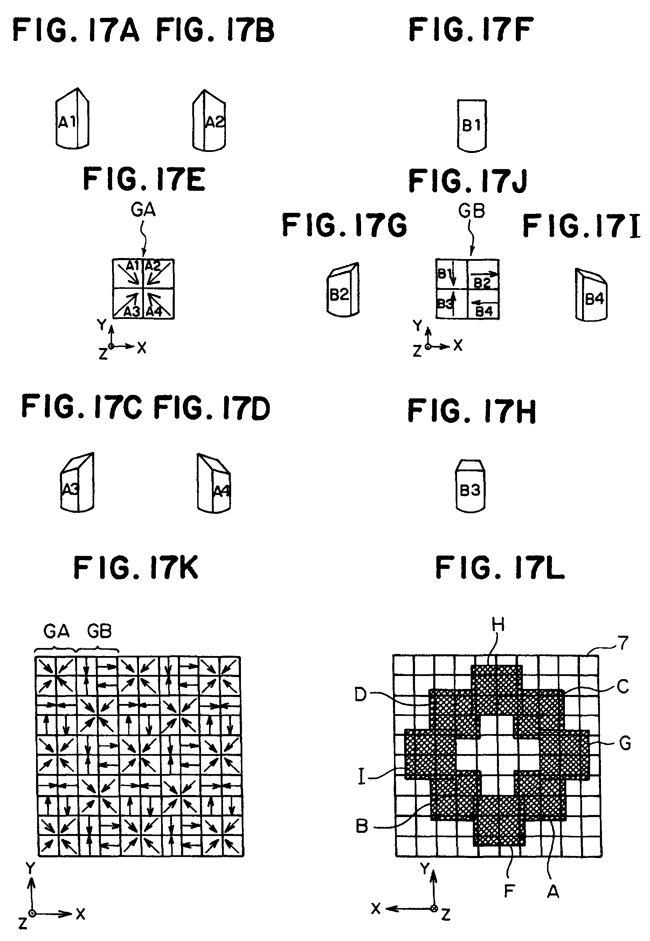

Namely, the first fly's eye lens 252 has a first lens element group GA shown in FIGS. 17A - 17E, and a second lens element group GB composed of four pieces of lens elements B1 - B4 shown in FIGS. 17F - 17I. Herein, the first lens element group GA has the same configuration as the lens element GA shown in FIGS. 16A - 16E. Then, the second lens element group is constructed of four pieces of lens elements B1 - B4 in which the apex angles θ are equal to each other, and the angles made by the azimuth straight lines L are each 90 degrees. At this time, as shown in FIG. 17J, the azimuth angles α of the azimuth straight lines of the lens elements B1 - B4 are 0 degree, ± 90 degrees and 180 degrees.

Then, as illustrated in FIG. 17K, the first lens element group GA constructed of the lens elements A1 - A4 and the second lens element group GB constructed of the lens elements B1 - B4, are disposed in a checkered pattern within the plane (the XY plane in the Figure) perpendicular to the optical axis. To be specific, the first fly's eye lens 252 is constructed so that an angle made by a group of the azimuth straight lines of the four lens elements A1 - A4 in the first lens element group GA and by a group of the azimuth straight lines of the four lens elements B1 - B4 in the second lens element group GB, is 45 degrees.

Eight pieces of areas A - I on the incident surface of the second fly's eye lens 7 are, as indicated by hatching in FIG. 17L, illuminated with the radiation beams penetrating the first fly's eye lens 252 having the eight azimuth angles (α =0 degree, ± 45 degrees, ± 90 degrees, ± 135 degrees, 180 degrees) shown in FIG. 17K.

Herein, the radiation beams exiting the respective lens elements A1 in the first lens element group GA are overlapped by the relay lens 6 and arrive at the area A in the illumination region shown in FIG. 17L. The radiation beams exiting the respective lens elements A2 in the first lens element group GA are overlapped by the relay lens 6 and arrive at the area B. The radiation beams exiting the respective lens elements A3 in the first lens element group GA are overlapped by the relay lens 6 and arrive at the area C. The radiation beams exiting the respective lens elements A4 in the first lens element group GA are overlapped by the relay lens 6 and arrive at the area D. Further, the radiation beams exiting the respective lens elements B1 in the second lens element group GB are overlapped by the relay lens 6 and arrive at the area F. The radiation beams exiting the respective lens elements B2 in the second lens element group GB are overlapped by the relay lens 6 and arrive at the area G. The radiation beams exiting the respective lens elements B3 in the second lens element group GB are overlapped by the relay lens 6 and arrive at the area H. The radiation beams exiting the respective lens elements B4 in the second lens element group GB are overlapped by the relay lens 6 and arrive at the area I. As obvious from FIG. 17L, illumination area formed of the whole of these areas A - I takes substantially an annular shape.

Herein, when an aperture stop 282 having the annular shaped apertures as shown in FIG. 15B is disposed on the exit surface of the second fly's eye lens, it is possible to illuminate at by far a higher efficiency (with-almost no loss of the radiation quantity) by use of the first fly's eye lens 252 than by using the first fly's eye lens equivalent to the conventional one. Note that the first and second lens element groups are arrayed alternately in the checkered pattern in the third embodiment and may also be arrayed in any patterns as explained in the first embodiment.

It is to be noted that the apex angles $\theta$ of the four lens elements A1 - A4 (B1 - B4) constituting the lens element group GA (GB) in the first fly's eye lenses 251, 252, however, the present invention is not limited to this mode. The number of the lens elements may be 4n (where n is a positive integer) such as 8 or 12. In such a case, an angle made by the azimuth straight line L of each of the 4n lens elements is 360/4n degrees.

The apex angles $\theta$ of four lens elements A1-A4 (B1-B4) constituting each lens element group GA (GB) are the same, but those apex angles may not be the same. If the apex angles $\theta$ of the lens elements A1 - A4 of the lens element group GA (GB) are differentiated, the deviation angles $\delta$ of the radiation beams exiting the lens elements A1 - A4 (B1 - B4) become different, with the result that the image of the first fly's eye lens shifts per lens element on the incident surface of the second fly's eye lens 7. It is therefore feasible to reduce an influence by deterioration in contrast that occurs at an edge of the aperture stop on the exit side of the second fly's eye lens 7, i.e., by fluctuations in the configurations of the secondary radiation sources.

Furthermore, in the second fly's eye lens 252 described above, the illumination efficiency can be more enhanced by differentiating an areal size of the illumination areas A - D (the azimuth angle a is ± 45 degrees, ± 135 degrees) through the first lens element group GA from an areal size of the illumination areas F - I (the azimuth angle $\alpha$ is 0 degree, ± 45 degrees and 90 degrees) through the second lens element group GB.

Moreover, in the second fly's eye lens 252, the focal lengths of the lens elements A1 - A4 of the first lens element group GA and the focal lengths of the lens elements B1 - B4 of the first lens element group GB, are not limited to the same focal length. Herein, for precisely illuminating a desired illumination area with the radiation and increasing the illumination efficiency, the focal lengths of the lens elements A1 - A4 and B1 - B4 may be arbitrarily set.

Further, in the second fly's eye lens 252, the apex angles $\theta$ of the lens elements A1 - A4 of the first lens element group GA and the apex angles $\theta$ of the lens elements B1 - B4 of the first lens element group GB, are not limited to the same apex angle. Herein, for preventing the decline in the contrast due to the ununiformity in the illuminance that occurs at the edge of the aperture stop, the apex angles of the lens elements A1 - A4 and B1 - B4 may be arbitrarily set.

The first and second fly's eye lenses 251, 252 include the plurality of lens elements in which the azimuth angles of the azimuth straight lines are the same, however, the focal lengths of the plurality of lens elements having the same azimuth angles are not necessarily the same (the areal sizes of the illumination areas through the lens elements having the same azimuth angles are not necessarily equal to each other). For instance, in the first fly's eye lens 251, if the foal lengths of the plurality of lens elements A1 having the same azimuth angle are set different from each other, it follows that the areas A having different areal sizes are overlapped on the second fly's eye lens 7. As a result, the radiation intensity distribution in the area A can be set to a desired distribution.

Now, the first fly's eye lens 253 has substantially the same configuration as the first fly's eye lens described above, and the apex angle $\theta$ of the lens element and the focal length of the lens element itself are optimized so that the illumination radiation beams can be guided with no loss of the radiation quantity to the apertures of the aperture stop 283, which are somewhat different in configuration from those of the aperture stop 281.

Next, one example of correspondence relations between the first fly's eye lenses 251 - 256 and the aperture stops 281 - 286 will be explained. When the aperture stop 281 including quadrupolar (4-aperture) radiation transmitting areas (the radiation shielding area is indicated by hatching in the Figure) is selected as an aperture stop, the first fly's eye lens 251 is selected. When the aperture stop 282 including an annular shaped radiation transmitting area is selected as an aperture stop, the first fly's eye lens 252 is selected. Then, when the aperture stop 283 taking a quadrupolar (4-aperture) shape different from the aperture stop 282 is selected as an aperture stop, the first fly's eye lens 253 is selected.

Further, when the aperture stop 284 having a small diameter (which may be referred to as a small σ illumination-oriented aperture stop) is selected as an aperture stop, the first fly's eye lens 254 having a large focal length is selected. When the aperture stop 285 having an intermediate diameter (which may be referred to as an intermediate σ illumination-oriented aperture stop) is selected as an aperture stop, the first fly's eye lens 255 having an intermediate focal length is selected. When the aperture stop 286 having a large diameter (which may be referred to as a large σ illumination-oriented aperture stop) is selected as an aperture stop, the first fly's eye lens 256 having a short focal length that is the same as the conventional one is selected. In the third embodiment also, the unillustrated main control unit controls the drive units so as to have the correspondence relations given above. The optimal illumination corresponding to the type of the reticle can be thereby attained in a state of minimizing the loss of quantity of the illumination radiation, and both of the resolution and the throughput can be enhanced at the same time.

(Fourth Embodiment)

Further, what has been used as the first fly's eye lens in the first to third embodiments includes the eccentric lens elements, i.e., the first fly's eye lens used therein is obtained by uniting the wavefront division type optical integrator with the radiation deflection member. The first fly's eye lens serving as the wavefront division type optical integrator and the radiation deflection member may also be composed of different members.

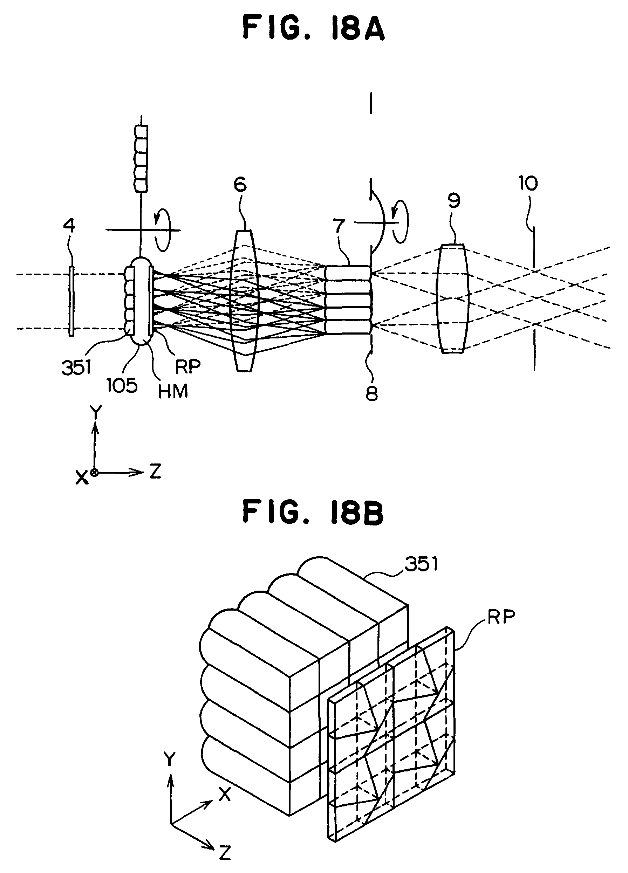

A fourth embodiment in which the wavefront division type optical integrator and the radiation deflection member are composed of different members, will hereinafter be described with reference to FIGS. 18A and 18B. Note that a construction of the projection exposure apparatus in the fourth embodiment shown in FIG. 18A is almost the same as the projection exposure apparatus in the first embodiment shown in FIG. 1 other than a configuration of the first fly's eye lens, and therefore its repetitive explanation is omitted. Further, the same components as those of the apparatus illustrated in FIG. 1 are marked with the same numerals.

Referring to FIG. 18A, a first fly's eye lens 351 equivalent to the conventional fly's eye lens is held integrally with a deflection prism RP by a holding member HM. In an example shown in FIG. 18A, a pitch (which implies a diameter-directional size of each of the prism elements constituting the deflection prism RP) of the deflection prism RP, is different from a pitch (which implies a diameter-directional size of each of lens elements constituting the first fly's eye lens 351) of the first fly's eye lens 351. In this construction also, it is possible to attain the illumination under the radiation intensity distribution localized on the incident surface of the second fly's eye lens 7 by deflecting action of the deflection prism RP. Note that the pitch of the deflection prism RP may be, as shown in FIG. 18B, set equal to the pitch of the first fly's eye lens 351.

Further, the first fly's eye lens 351 is not necessarily set integral with the deflection prism RP. For example, this geometry may be adopted, wherein the first fly's eye lens 351 is fixed to the optical axis of the illumination optical system, and the deflection prism RP is so disposed as to be insertable in the optical path between the first fly's eye lens 351 and the relay optical system. Furthermore, the deflection prism is not confined to one type, and plural types of deflection prisms may also be so disposed as to be insertable in the optical path described above in order to obtain an optimal state corresponding to a plurality of shapes of the apertures of the aperture stop. Moreover, in this construction, the plurality of first fly's eye lenses with their focal lengths different from each other are provided in an exchangeable manner without fixing the first fly's eye lens 351 within the optical path, and the plural types of deflection prisms may be provided in the exchangeable way.

(Fifth Embodiment)

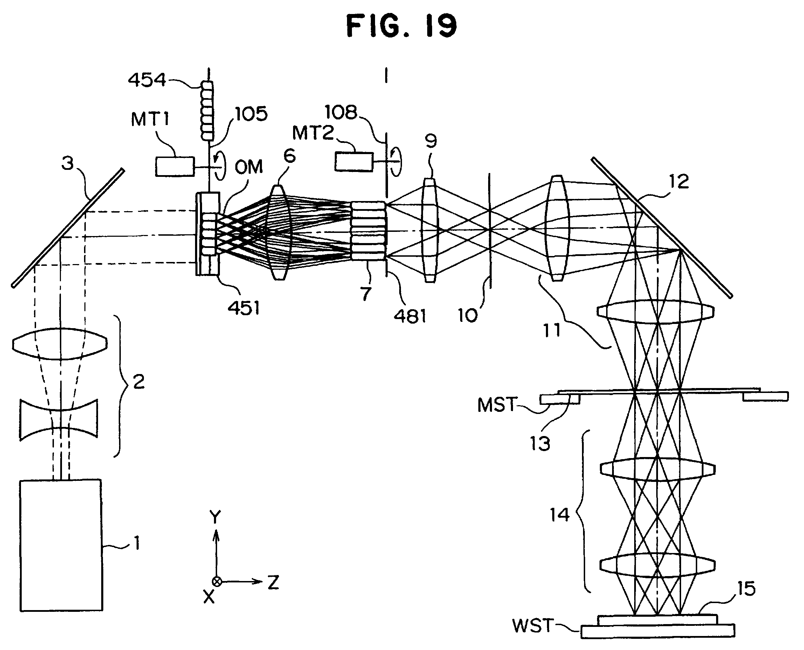

Next, a fifth embodiment in which the wavefront division type optical integrator and the radiation deflection member are composed of different members, will hereinafter be described with reference to FIGS. 19 through 26C. Note that a construction of the projection exposure apparatus in the fifth embodiment shown in FIG. 19 is almost the same as the projection exposure apparatus in the first embodiment shown in FIG. 1, and therefore the repetitive explanation of the construction of he whole apparatus is omitted. Further, the same components shown in FIG 19 as those of the apparatus in FIG. 1 are marked with the same numerals.

Differences of the projection exposure apparatus in the fifth embodiment illustrated in FIG. 19 from the projection exposure apparatus in FIG. 1, are configurations of the first fly's eye lens and of the aperture stop.

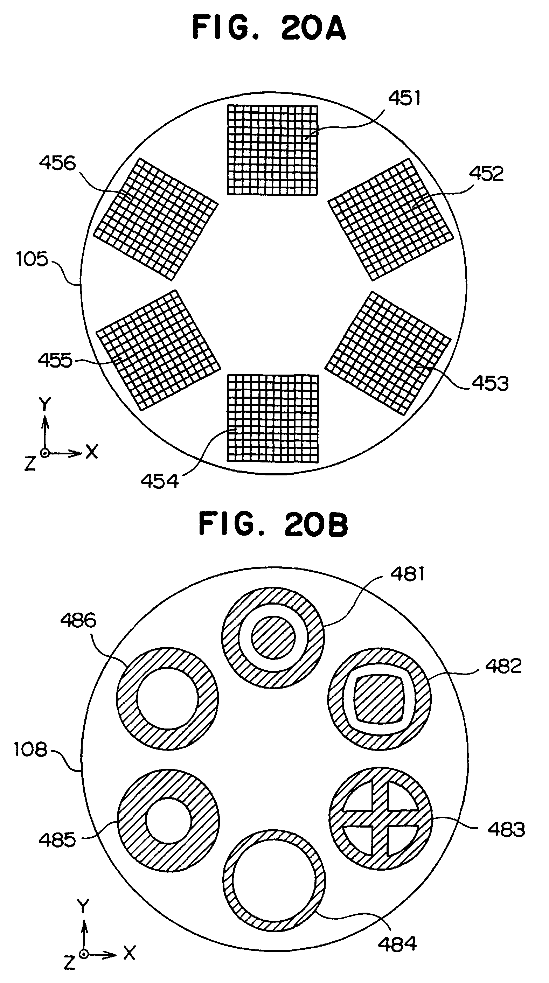

FIG. 20A is a view showing a structure of the revolver 105 provided with a plurality of first fly's eye lenses 451 - 456 in the projection exposure apparatus in the fifth embodiment. FIG. 20B is a view showing a structure of the revolver 108 provided with aperture stops 481 - 486.

In the fifth embodiment, as shown in FIG. 20A, the plurality of first fly's eye lenses 451 - 456 are fitted onto the revolver 105, and one of the plurality of first fly's eye lenses 451 - 456 can be selectively positioned within the optical path of the illumination apparatus. Note that the plurality of first fly's eye lenses 451 - 456 are structured so that the illumination areas on the incident surface of the second fly's eye lens 7 are different from each other.

Further, as shown in FIG. 20B. the plurality of aperture stops 481 - 486 provided on the revolver 108 are structured so that the aperture configurations thereof are different from each other. The aperture stops 481 - 486 are provided on the revolver 108 so that one of the plurality of aperture stops 481 - 486 can be selectively positioned within the optical path of the optical system. In accordance with the fifth embodiment, these revolvers 105, 108 are, as in the first embodiment, rotationally driven by the drive units controlled by the main control unit of the projection exposure apparatus. One of the plurality of aperture stops 481 - 486 and one of the plurality of first fly's eye lenses 451 - 456 are thereby positioned within the optical path of the illumination apparatus, corresponding to the illumination conditions required.

Next, the first fly's eye lenses 451 - 456 will respectively explained. It is to be noted that the first fly's eye lenses 454 - 456 are equivalent to the conventional fly's eye lenses. The first fly's eye lens 454 is equivalent to the first fly's eye lens 51 in the first embodiment. The first fly's eye lens 455 is equivalent to the first fly's eye lens 53 in the first embodiment. The first fly's eye lens 456 is equivalent to the first fly's eye lens 52 in the first embodiment.

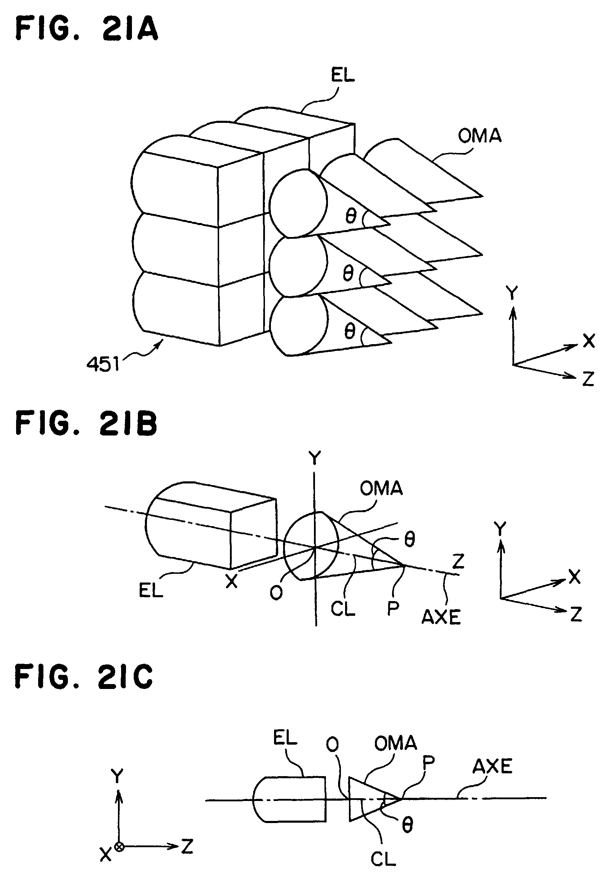

FIGS. 21A - 21C are views showing the first fly's eye lens 451 and an optical member OMA as a radiation deflection member. As shown in FIG. 21A, the first fly's eye lens 451 is configured such that a plurality of lens elements EL are integrated in the two-dimensional matrix on the XY plane, and a plurality of optical members each taking such a shape as to have at least partially a conical shape are disposed on the exit sides (on the mask-side) of the lens elements EL, corresponding to the plurality of lens elements EL. FIGS. 21B and 21C are views each showing a layout relation between the lens element EL and the optical member OMA, focusing on one of the plurality of lens elements EL.

Referring to FIGS. 21B and 21C, a direction of the optical axis AXE of the lens element EL is set as a Z-axis, there are given a center O of a circular bottom surface of the conical shaped optical member OMA and an apex P thereof, and a straight line connecting the apex P to the center O is set as a central axis CL. Herein, the central axis CL is coincident with the optical axis AXE.

A plane (YZ plane) when the conical shaped optical member OMA is cut perpendicularly to the central axis CL, takes the same configuration as the optical prism, and hence the same refractive action as the optical prism occurs. Therefore, when the parallel radiation beams are, when incident, refracted as shown in FIG. 22A, and a central area on an irradiation surface IP is not illuminated with the radiation. The same refractive action occurs in all the optical members OMA, and therefore, when the irradiation surface IP is rotated about the central axis CL (the optical axis AXE), the radiation beams exiting the conical shaped optical member OMA fall on the irradiation surface as an annular shaped illumination as shown by hatching in FIG. 22B.

In the fifth embodiment, the conical shaped optical member OMA is disposed on the exit side of one single lens element EL of the lens elements constituting the first fly's eye lens 451, so that the radiation beams exiting the single lens element EL travel along an optical path shown in FIG. 22C, and the area on the incident surface of the second fly's eye lens 7 is illuminated with the radiation beams forming the annular shape. Then, in accordance with the fifth embodiment, the conical shaped optical member OMA is disposed on the exit side of the lens element EL, corresponding to each of the lens elements EL of the first fly's eye lens 451, and consequently the radiation beams from the respective optical members OMA are overlapped on the incident surface of the second fly's eye lens 7, with the result that the annular shaped area shown by hatching in FIG. 22D is illuminated with these radiation beams. It is therefore feasible to execute the illumination through the annular shaped stop 481 including the annular shaped radiation transmitting portion with a much smaller loss of the radiation quantity than in the conventional fly's eye lens.

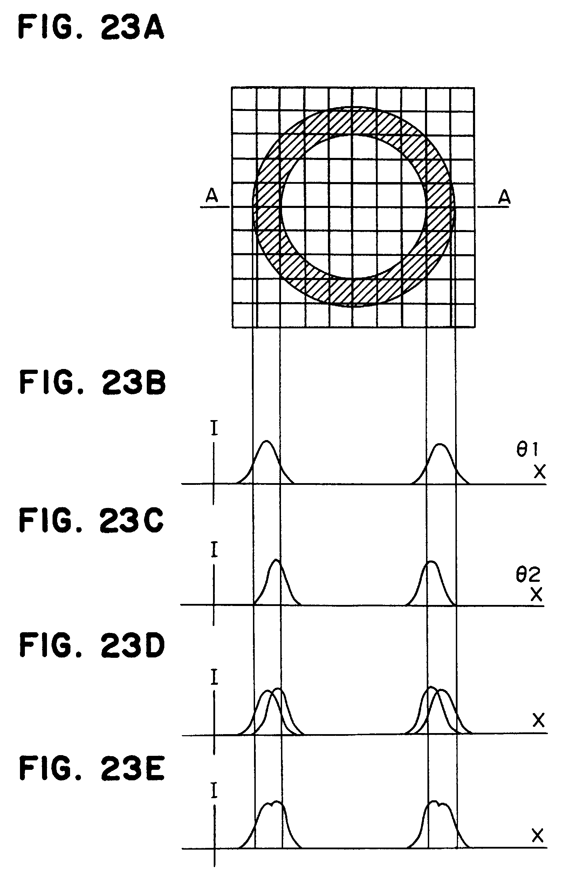

In the first fly's eye lens 451 described above, there has been explained the case where the plurality of optical members OMA each having the same apex angle θ, and it is possible to prevent a decrease in marginal radiation quantity on the incident surface of the second fly's eye lens 7 by making different the apex angles θ of the conical shaped optical members OMA. For instance, there is presumed a case where two types of optical members, i.e., optical members OMA1 each having an apex angle θ1 and optical member OMA2 each having an apex angle θ2 different from θ1, are properly disposed. A hatching area in FIG. 23A is an illumination area on the incident surface of the second fly's eye lens 7. Then, FIGS. 23B - 23E show illumination radiation intensity distributions at portions, cut by the line A-A, the positions are given on the axis-of-abscissa X, and the intensities of the illumination radiation are given on the axis-of-ordinates I. The illumination radiation beam penetrating the optical member OMA1 having the apex angle θ1 and is then refracted, has the radiation intensity distribution shown in FIG. 23B. By contrast, the illumination radiation beam penetrating the optical member OMA2 having the apex angle θ2 and is then refracted, has the radiation intensity distribution shown in FIG. 23C, of which a peak shifts as compared with FIG. 23B. Then, FIG. 23D shows what these two intensity distributions are overlapped with each other. When finally synthesizing these two intensity distributions, as shown in FIG. 23E, it is possible to obtain a uniform intensity distribution in which the illuminance does not abruptly decline at the periphery of the annular shaped illumination area. Further, even when using the plurality of optical members OMA having the same apex angles θ, the uniform intensity distribution can be obtained by shifting or tilting the optical member OMA with respect to the optical axis of each lens element. Further, even when using the optical members OMA having the apex angle θ, the same effect as the case of using the optical members OMA1, OMA2 having the different apex angles θ can be acquired by differentiating the focal lengths of the lens elements EL of the first fly's eye lens 451, and the decline in the marginal radiation quantity can also be prevented.

FIGS. 24A -24C are views showing configurations of the first fly's eye lens 452 and of an optical member OMB as the deflection member. As shown in FIG. 24A, the first fly's eye lens 452 is constructed such that the plurality of lens elements EL are integrated in the two-dimensional matrix on the XY plane, and a plurality of optical members each taking such a shape as to have at least partially a quadrangle cone are disposed on the exit sides (on the mask-side) of the lens elements EL, corresponding to the plurality of lens elements EL. FIGS. 24B and 24C are views each showing a layout relation between the lens element EL and the optical member OMB, focusing on one of the plurality of lens elements EL.

FIG. 24D is a view showing an illumination area on the incident surface of the second fly's eye lens 7. The radiation beams penetrating the quadrangle cone shaped optical member OMB fall on an area on the incident surface of the second fly's eye lens 7 so as to form a shape shown by hatching in FIG. 24D by the refractive action of the optical member OMB as an optical prism as in the first embodiment. Accordingly, the illumination can be effected at a high efficiency in the case of selecting an aperture stop 482 assuming a deformed annular shape shown in FIG. 20B.

The discussion on the first fly's eye lens 452 is made with respect to the case where the straight line connecting the apex P of the quadrangle cone shaped optical member OMB to the center O of the bottom surface is set as the central axis CL, ξ is an angle (of a pyramid) made by the central axis CL and by a surface having power (refracting power), and the plurality of optical members OMB having the same apex angle ξ are disposed. It is, however, possible to prevent the decline in the marginal radiation quantity on the incident surface of the second fly's eye lens 7 and obtain the illumination radiation exhibiting the uniform intensity distribution as in the case of the conical shaped optical members having the different apex angles θ by making the apex angles ξ of the pyramids of the optical members OMB from each other.

Further, the same effect as the effect when the angle δ is changed can be also obtained by differentiating the focal lengths of the lens elements EL of the first fly's eye lens 452 from each other. Moreover, the illuminance efficiency for the deformed annular shaped stop can be increased by making the angle ξ different with respect to each of the surfaces of the quadrangle cone. As a matter of course, the configuration of the optical member OMB is not limited to the quadrangle cone and may be a polygonal shape having n-angles (n is an integer of 5 or larger). The polygonal cone shaped optical member exhibits the same refractive action as that of the conical shaped optical member, and is capable of performing the illumination assuming a sharper annular configuration as the numerical value of n increases. Further, the layout is that the exit-surface-sided square portion of the lens element EL is aligned with the square portion of the bottom surface of the quadrangle cone shaped optical member OMB. The layout is not, however, limited to this and may include, for example, such a geometry that the optical member OMB is disposed in a state of being rotated through approximately 45 degrees about the optical axis AXE.

Now, in the fifth embodiment, the inclined surface in the YZ section of the conical shaped optical member OMA (OMA1, OMA2) appears to be a straight line as shown in FIG. 21C, however, the surface having the power (refracting power) of the conical shaped optical member OMA (OMA1, OMA2) may also be formed as a curved surface. In this case, there is an advantage that there can be attained the illumination with an extremely small loss of the radiation quantity with respect to the deformed annular stop.

Further, in the fifth embodiment, the angular cone shaped inclined surface is, as shown in FIG. 24A, a flat surface. As illustrated in FIG. 25B, however, the surface having the refracting power of the angular cone shaped optical member is formed as the curved surface, whereby there can be attained the illumination with an extremely small loss of the radiation quantity with respect to the deformed annular aperture stop.

Moreover, the fifth embodiment uses the optical member taking the cone shape (the conical shape, the polygonal cone shape) as a whole. For example, as shown in 25C and 25D, however, there may also be used an optical member assuming a configuration, a part of which takes a cone shape (the conical shape, the polygonal cone shape). In this case, an area containing the optical axis on the incident surface of the second fly's eye lens 7 can be illuminated with the radiation beams. As a result, it is feasible to carry out the illuminations such as an annular illumination having the radiation intensity in the area containing the optical axis on a pupil surface and on a surface conjugate with the pupil surface, a quadrupolar (4-apeture) illumination, and an 8-pole (8-apeture) illumination. Note that an optical member OMC shown in FIG. 25C takes a configuration in which an apex portion of the conical shape is cut off. A cut surface thereof is a flat surface but is not limited to the flat surface, and may also be a curved surface. Further, an optical member OMD shown in FIG. 25D assumes a configuration in which an apex portion of the angular cone is cut off. A cut surface thereof is a flat surface but is not limited to the flat surface, and may also be a curved surface.

Moreover, the fifth embodiment has given the discussion on the case where the optical member OMA (OMB) including at least partially the cone shape (the conical shape, the polygonal cone shape), is disposed on the exit side (on the side of the mask 13) of the first fly's eye lens 451 or 452. The disposition of the optical member is not, however, confined to this position. The optical member OMA (OMB) may be disposed on the side of the radiation source 1 from the first fly's eye lens 451 (452). Moreover, FIGS. 21A and 24A show the example of the layout, wherein the bottom surface of the optical member OM etc faces to the exit surface of the first fly's eye lens 451 (452). The present invention is not, however, limited to this layout and may embrace a layout in which the bottom surface of the optical member OM etc faces to the apex O of the first fly's eye lens 451 etc.

Further, in the fifth embodiment, the first fly's eye lens 451 (452) and the optical member OMA (OMB) are disposed spatially apart from each other, however, it is desirable that these two members be integrally formed. Note that this integral formation implies that the lens element EL is closely fitted to the optical member OMA (OMB), and is a concept embracing, e.g., cementing the lens element to the optical member by use of a bonding agent, closely fitting them to each other, and forming the lens element and the optical member by use of one member, and so on. Thus, the integral formation enables an error occurred in manufacturing to decrease. Then, since the two members are integral, there is an advantage that the predetermined illumination area is always precisely illuminated with the radiation beams.

Further, the first fly's eye lens 451 (452) and the optical member OMA (OMB) are integrally held on the revolver 105, and hence there is no necessity of aligning the first fly's eye lens and the optical member with each other when the first fly's eye lens 451 (452) and the optical member OMA (OMB) are selected out of the plurality of first fly's eye lenses and the plurality of optical members. Then, as in the case described above, because of the two members being integral, there is the advantage that the predetermined illumination area is always precisely illuminated with the radiation beams.

Further, in accordance with the fifth embodiment, as shown in FIGS. 26A - 26C, the first fly's eye lens serving as the wavefront division type optical integrator and the optical member OMA (OMB) as the radiation deflection member, may also be provided on the separate revolvers. In this case, as shown in FIG. 26A, a plurality of fly's eye lenses 454 - 456 having focal lengths different from each other are provided on a revolver 105A. Then, as illustrated in FIG. 26B, a revolver 105B is formed with an aperture AP and provided with the optical member OMA and the optical member OMB. These revolvers 105A, 105B are disposed adjacent to each other as shown in FIG. 26C.

Then, one of the plurality of first fly's eye lenses 454 - 456, the aperture AP, and one of the optical members OMA, OMB are positioned within the optical path of the illumination apparatus. Accordingly, on the occasion of the normal illumination, one of the plurality of first fly's eye lenses 454 - 456 and the aperture AP are positioned within the optical path. In the case of the modified illumination (the annular illumination, the multipolar illumination etc.), one of the plurality of first fly's eye lenses 454 - 456 and one of the optical members OMA, OMB are positioned within the optical path. In this case, a size of the annular shaped or multi-pole shaped illumination area formed on the second fly's eye lens 7 can be made variable by change in focusing length caused by exchanging the first fly's eye lenses 454 - 456.

Further, there may be taken a construction in which the first fly's eye lens is fixedly disposed within the optical path, and the optical members are switched over. In this case, the revolver 105B shown in FIG. 26B may be disposed adjacent to the first fly's eye lens fixedly disposed in the optical path of the illumination apparatus. At this time, if a zoom lens is used as a relay optical system disposed between the first and second fly's eye lenses, the size of the annular shaped or multi-pole shaped illumination area formed on the second fly's eye lens 7 can be made variable.

Furthermore, coating is applied on the incident surface and the exit surface of the optical member taking the cone shape (the conical shape, the polygonal cone shape), whereby a reflection by the conical optical member can be prevented.

Further, in the fifth embodiment, one single optical member OMA (OMB) is disposed corresponding to one single lens element EL (which may be called a one-to-one correspondence layout), however, a plurality of optical members may also be provided corresponding to one lens element (which may be called a one-to-multi correspondence layout).

The optical member OMA (OMB) taking the cone shape (the conical shape, the polygonal cone shape) of which the section is convex, is used in the fifth embodiment, however, the same illumination effect can be obtained by using the optical member OMA (OMB) taking a cone shape (a hollowed cone or a hollowed angular cone formed by hollowing, in a conical shape or polygonal cone shape, a circular or polygonal cylindrical optical member) having a hollowed section.

Furthermore, the plurality of optical members of which the section assume the solid cone shape and the plurality of optical members of which the section takes the hollowed cone shape, are disposed corresponding to the lens elements of the first fly's eye lens. When at least one group of the optical members are moved, the annular shaped illumination area on the incident surface of the second fly's eye lens can be changed.

Moreover, the relay lens system is composed of the zoom optical system, whereby the area can be illuminated with the radiation beams in the annular shape or the multi-pole shape having an arbitrary size.

(Sixth Embodiment)

In the first through fifth embodiments discussed above, the fly's eye lenses constructed by integrating the plurality of optical elements are applied as the first and second optical integrators, however, the present invention is not limited to the fly's eye lenses.

An example where the same first fly's eye lens as those in the embodiments discussed above is used, and a rod type integrator having an internal reflection surface extending in the optical-axis direction is disposed as the second fly's eye lens, will hereinafter be explained by way of a sixth embodiment. Herein, FIG. 27 is a view showing the principal components of the projection exposure apparatus in the sixth embodiment. Note that the construction of the projection exposure apparatus in the sixth embodiment shown in FIG. 27 is substantially the same as the projection exposure apparatus in the first embodiment shown in FIG. 1, except for a layout from the first fly's eye lens down to the reticle serving as a surface to be illuminated, and therefore its repetitive explanation of the construction of the whole projection exposure apparatus is omitted. Further, the same components as those of the apparatus in FIG. 1 are marked with the same numerals.

Referring to FIG. 27, the first fly's eye lens 55 is the same as the lens 55 in the first embodiment discussed above, and a planar radiation source (a secondary radiation source) consisting of a plurality of illuminant images is formed on a surface P1 on the exit side thereof. The relay optical system 106 and a rod type integrator 107 are disposed on the exit side of the first fly's eye lens 55, the image of the planar radiation source (the secondary radiation source) formed by the first fly's eye lens 55, is formed through the relay optical system 106 on the incident surface of the rod type integrator 107 or on a plane P2 positioned in the vicinity of this incident surface. Then, the radiation beams incident on the rod type integrator 107 are repeatedly reflected by the internal surface of the rod type integrator 107, and thereafter exit the exit surface thereof. At this time, it follows that the exit surface of the rod type integrator 107 is illuminated with the radiation beams in a state where the radiation beams from the planar radiation source in such a configuration that as if virtual images of the plurality of radiation sources expand in the position of the surface P2. Namely, the rod type integrator as the second optical integrator forms the substantial planar radiation source on the plane P2.

Then, a reticle blind 110 as a field stop for defining the illumination region on a surface (a surface 04) of a reticle 13 as a surface to be illuminated, is disposed on the exit surface of the rod type integrator 107 or in a position in the vicinity of this exit surface. An image of this reticle blind 110 is projected through a reticle blind image forming optical system 111 on the reticle 13. Herein, an illumination aperture stop 85 having apertures in a predetermined shape is disposed on a plane P3 inside the reticle blind image forming optical system 111. Referring to FIG. 27, a plane 01 on which the incident surface of the fly's eye lens 55 (51) is positioned, a plane 02 in the relay optical system 6, a plane 03 and a surface 04 (the reticle 13), are optically conjugate with each other. Then, the planes P1, P2, P3 are conjugate with each other, and have a positional relation conjugate with a pupil of the projection optical system 14.

As shown in FIG. 27, the first fly's eye lens 55 having the same structure as in the first embodiment is disposed in the optical path, the incident surface of the rod type integrator 107 or the plane P2 (in the vicinity of this incident surface) is illuminated with the radiation beams in an oblique direction, which are deflected by the exit surface of the first fly's eye lens 55. Namely, the middle-through radiation beams arrive at the plane P2. At this time, it is observed from the exit surface of the rod type integrator 107 that the virtual images of the radiation sources existing in concentration in a quadrupolar (4-aperture) shape are formed on the plane P2. Then, since the planes P2, p3 are conjugate with each other, it follows that the planar radiation source consisting of real images of the radiation sources existing in concentration in the quadrupolar (4-aperture) shape, is formed on the plane P3. Accordingly, even when the reticle 13 is illuminated in the oblique direction with the radiation beams by use of the illumination aperture stop 85 having the quadrupolar (4-aperture) shaped apertures, it is feasible to attain the illumination at a high efficiency with almost no loss of the radiation quantity. Note that the first fly's eye lens having the same structure as in the second through fourth embodiments discussed above, and what the optical member and the first fly's eye lens in the fifth embodiment are combined may also be used instead of the first fly's eye lens 55 in FIG. 27. Further, the zoom optical system may be used as the relay optical system 6. Moreover, an integrator utilizing a total reflection by an internal surface of a glass rod composed of a material such as silica and fluorite, and an integrator of such a type that a reflection film is provided on an internal surface of a hollowed cylindrical (a circular cylindrical or polygonal (preferably, quadrangle) cylindrical pipe may be applied as the rod type integrator 107.

Note that the wavefront division type optical integrator and the radiation deflection member in the first to sixth embodiments discussed above, are not limited to the combinations given in the respective embodiments. For instance, there may be incorporated at least one of combinations, i.e., a combination of the revolver 105 in the first embodiment with the first fly's eye lens and the radiation diffusion member in the second embodiment, a combination of the first fly's eye lens in the third embodiment with the first fly's eye lens and the deflection prism in the fourth embodiment, and a combination of the first fly's eye lens and the optical member in the fifth embodiment.

Note that the illumination apparatus or the exposure apparatus according to the present invention is assembled by electrically, mechanically or optically connecting the respective elements shown in the first through sixth embodiments discussed above.

Next, one example of an operation when a predetermined circuit pattern is formed on a wafer by use of the projection exposure apparatus in the embodiments discussed above, will be explained referring to a flowchart in FIG. 28.

To start with, in step 101 in FIG. 28, a metal film is deposited on a 1-lot wafer. In next step S102, a photo resist is applied on the metal film on the 1-lot wafer. Thereafter, in step 103, a pattern image on the reticle R is sequentially transferred by exposure onto respective shot areas on the 1-lot wafer by use any one of the projection exposure apparatuses in the first to sixth embodiments. Thereafter, in step 104, the photo resist on the 1-lot wafer is developed. After the development, in step 105, etching is effected on the 1-lot wafer, wherein the resist pattern serves as a mask. A circuit pattern corresponding to the pattern on the reticle R is formed on each of the shot areas on the wafer. Thereafter, a circuit pattern on a higher layer is formed, and so on, thereby manufacturing a device such as a semiconductor device, etc.

Now, in each of the embodiments discussed above, the fly's eye lens constructed by integrating the plurality of lens elements is used as the wavefront division type optical integrator, however, an integral member subjected to press-working to have the same whole configuration as the fly's eye lens in each of the embodiments described above, may also be used as the above fly's eye lens.

Moreover, in each of the embodiments described above, a one-dimensional (or two-dimensional) oscillation mirror for preventing an occurrence of speckles (interference fringes) on the surface of the reticle 13, may be disposed in the optical path between the wavefront division type optical integrator and an auxiliary optical integrator.

Further, in the example where the wavefront division type optical integrator is formed integrally with the radiation deflection member in the embodiment described above, the geometry is that the exit surface of the plano-convex lens element is inclined to the optical axis. The exit surface of this lens element is not, however, confined to the flat surface and may be a surface having a curvature as on a convex or concave surface. In this case, it is enough that an axis (which connects a center of the curvature of the surface to a center of an effective area o the surface) of the surface having the curvature, is simply inclined to the optical axis.

Moreover, the lens element of the wavefront division type optical integrator is not limited to the lens element having a positive refracting power and may also be a lens element having a negative refracting power.

Furthermore, in the examples given above, the radiation deflection member is provided corresponding to the wavefront division type optical integrator, however, there may be taken such a construction that only the radiation deflection member is provided. In this case, the radiation deflection member wavefront-divides a beam of radiation incident on this radiation deflection member into at least six beams of radiation, and it is preferable that at least these six beams of radiation be deflected in directions different from each other.

Now, the illumination radiation for the exposure in the embodiments discussed above may involve the use of ultraviolet rays having a wavelength of 100 nm or larger, i.e., a g-line (having a wavelength of 436 nm), an i-line (having a wavelength of 365 nm), and Deep Ultra Violet (DUV) radiation such as a KrF excimer laser beam (having a wavelength of 248 nm); and a Vacuum Ultra Violet (VUV) radiation such as an ArF excimer laser beam (having a wavelength of 193 nm) and an F2 laser beam (having a wavelength of 157 nm). In the exposure apparatus with the F2 laser used as a radiation source, it is preferable that a reflection type optical system (a cataptric optical system) or catadioptric optical system be adopted as the projection optical system. It is also preferable that all the optical elements (lens elements) used for the illumination optical system and the projection optical system as well be composed of fluorite. Then, the air within the F2 laser radiation source, the illumination optical system and the projection optical system is replaced with helium gas, and spaces between the illumination optical system and the projection optical system and between the projection optical system and the wafer are filled with helium gas. Further, in the exposure apparatus using the F2 laser, there is used a reticle composed of any one of fluorite, synthetic silica doped with fluorine, magnesium fluoride and quartz crystal.

It is to be noted that higher harmonics of a solid-state laser such as a YAG laser having an oscillation spectrum in any one of wavelengths, e.g., 248 nm, 193 nm and 157 nm, may be used instead of the beams of the excimer laser. There may also be used the higher harmonics obtained in such a way that single wavelength laser beams in an infrared region or visible region which are oscillated from a DFB semiconductor laser or a fiber laser, are amplified by a fiber amplifier doped with, e.g., eribium (or both of eribium and yttrium), and a wavelength conversion into the ultraviolet rays is carried out by use of a non-linear optical crystal. For example, if an oscillation wavelength of the single wavelength laser is set within a range of 1.51 ~ 1.59 μm, there are outputted 8-fold harmonics of which an occurrence wavelength falls within a range of 189 ~ 199 nm, or 1-fold harmonics of which an occurrence wavelength falls within a range of 151 ~ 159 nm. Especially when the oscillation wavelength is set within a range of 1.544 ~ 1.553μm, there are obtained the 8-fold harmonics within a range of 193 ~ 194 nm, i.e., the ultraviolet rays having substantially the same wavelength of that of the ArF excimer laser. When the oscillation wavelength is set within a range of 1.57 ~ 1.58μm, there are obtained the 10-fold harmonics within a range of 157 ~ 158 nm, i.e., the ultraviolet rays having substantially the same wavelength of that of the F2 laser. Further, when the oscillation wavelength is set within a range of 1.03 ~ 1.12μm, there are outputted 7-fold harmonics of which an occurrence wavelength falls within a range of 147 ~ 160 nm. Especially when the oscillation wavelength is set within a range of 1.099 ~ 1.106 μm, there are obtained the 7-fold harmonics of which an occurrence wavelength falls within a range of 157 ~ 158 nm, i.e., the ultraviolet rays having substantially the same wavelength of that of the F2 laser. Note that the single wavelength oscillation laser involves the use of an yttrium doped fiber laser.

Moreover, each of the embodiments discussed above can be applied to both of a step-and-repeat type (batch exposure type) projection exposure apparatus in which after finishing an exposure of one shot area on the wafer W to the radiation of the pattern image of the reticle R, a wafer stage WS is driven by stepping to move a next shot area on the wafer to the exposure area of the projection optical system PL, and the batch exposure is repeatedly executed, and a step-and-scan type projection exposure apparatus in which the reticle R and the wafer W are synchronously scanned in a way of setting a projection magnification β as a speed ratio with respect to the projection optical system PL when exposing each shot area on the wafer W to the radiation.

By the way, not only a reduction system but also an unit magnification system or an enlargement system (as used in the exposure apparatus for manufacturing a liquid crystal display) are usable as the projection optical system. Further, the present invention is applicable to a proximity type exposure apparatus.

Moreover, the present invention can be applied, in addition to the exposure apparatus used for manufacturing the semiconductor device, an exposure apparatus, used for manufacturing a display including a liquid crystal display device, for transferring a device pattern onto a glass plate, an exposure apparatus, used for manufacturing a thin-film magnetic head, for transferring a device pattern onto a ceramic wafer, and an exposure apparatus used for manufacturing an imaging device (CCD etc). Furthermore, the present invention can be applied to an exposure apparatus for transferring a circuit pattern onto a glass substrate or a silicon wafer in order to manufacture the reticle or the mask.

As discussed above, the present invention is not limited to the embodiments described above and may take a variety of constructions.

**Claims**

1. An illumination apparatus for illuminating a surface to be illuminated with radiation, comprising:

   a radiation source for generating a beam of radiation having a predetermined wavelength;
   a wavefront division type optical integrator, including a plurality of unit optical systems, for wavefront-dividing the beam of radiation from said radiation source an forming a plurality of radiation source images from a plurality of wavefront-divided radiation beams;
   a condenser optical system for leading the beams of radiation from said wavefront division type optical integrator to the surface to be illuminated; and
   a plurality of auxiliary optical members for deflecting the beams of radiation through said unit optical systems,
   wherein at least one of said auxiliary optical members is disposed corresponding to one of said unit optical systems.

2. An illumination apparatus according to claim 1, wherein

   said plurality of auxiliary optical members are disposed in a one-to-one correspondence relation with each of said all unit optical systems.

3. An illumination apparatus according to claim 1, wherein

   said plurality of auxiliary optical members are disposed between said wavefront division type optical integrator and the surface to be illuminated.

4. An illumination apparatus according to claim 1, wherein

   said auxiliary optical member deflects the beam of radiation through said unit optical system in at least two directions.

5. An illumination apparatus according to claim 1,
   wherein an auxiliary optical integrator for forming a substantial planar radiation source on the basis of the radiation from the plurality of radiation source images by said wavefront division type optical integrator, is disposed between said wavefront division type optical integrator and said condenser optical system, and

   said condenser optical system guides the radiation from the substantial planar radiation source by said auxiliary optical integrator, to the surface to be illuminated.

6. An illumination apparatus according to any one of claims 1 to 5,

wherein at least some of the beams of radiation deflected by said auxiliary optical members are guided to an area that does not contain the optical axis on a predetermined surface.

7. A projection exposure apparatus for illuminating a mask by use of an illumination apparatus for supplying exposure radiation, and projecting a pattern on said mask onto a workpiece through a projection optical system, comprising:

said illumination apparatus as set forth in claim 6,
wherein the predetermined surface is conjugate with a pupil surface of said projection optical system or with a portion in the vicinity of the pupil surface.

8. An illumination apparatus for illuminating a surface to be illuminated with radiation, comprising:

a radiation source for generating a beam of radiation having a predetermined wavelength;
a wavefront division type optical integrator for wavefront-dividing the beam of radiation from said radiation source an forming a plurality of radiation source images from a plurality of wavefront-divided radiation beams;
a condenser optical system for leading the beams of radiation from said wavefront division type optical integrator to the surface to be illuminated; and
a radiation deflection member for deflecting the plurality of wavefront-divided beams of radiation in at least two or more directions different from each other.

9. An illumination apparatus according to claim 8, wherein

said wavefront division type optical integrator is formed integrally with said radiation deflection member.

10. An illumination apparatus according to claim 1, wherein

an auxiliary optical integrator for forming a substantial planar radiation source on the basis of the plurality of radiation sources formed by said wavefront division type optical integrator, is disposed between said wavefront division type optical integrator and the surface to be illuminated, and

a radiation diffusion member is disposed closer to said radiation source than said auxiliary optical integrator.

11. An illumination apparatus according to claim 8, further comprising:

another optical integrator, so provided as to be exchangeable with at least said wavefront division type optical integrator, for forming a substantial planar radiation source on the basis of the beam of radiation from said radiation source.

12. An illumination apparatus according to claim 11, wherein

said another optical integrator is so provided as to be exchangeable with said wavefront division type optical integrator and said radiation deflection member.

13. An illumination apparatus according to claim 11, wherein

said another optical integrator is so provided as to be exchangeable with only said wavefront division type optical integrator.

14. An illumination apparatus according to claim 8, wherein

said wavefront division type optical integrator and said radiation deflection member are optical members different from each other.

15. An illumination apparatus according to claim 8, wherein

said radiation deflection member includes at least one auxiliary optical member for deflecting only one beam of radiation among the plurality of wavefront-divided beams of radiation.

16. An illumination apparatus according to claim 15, wherein

said radiation deflection member includes said plurality of auxiliary optical members, and said auxiliary optical member is formed integrally with said wavefront division type optical integrator.

17. An illumination apparatus according to claim 8, wherein

said radiation deflection member includes a first auxiliary optical member for deflecting at least one beam of radiation among the plurality of wavefront-divided beams of radiation in at least two directions, and a second auxiliary optical member for deflecting another beam of radiation different from at least the above one beam of radiation among the plurality of beams of radiation in at least two directions.

**18.** An illumination apparatus according to claim 17, wherein

the two directions by said first auxiliary optical member are the same as the two directions by said auxiliary optical member.

**19.** An illumination apparatus according to claim 17, wherein

said first auxiliary optical member and said second auxiliary optical member are disposed apart from said wavefront division type optical integrator.

**20.** An illumination apparatus according to claim 8, wherein

said radiation deflection member includes a first auxiliary optical member for deflecting only one beam of radiation among the plurality of wavefront-divided beams of radiation, and a second auxiliary optical member for deflecting only another beam of radiation different from the above one beam of radiation among the plurality of wavefront-divided beams of radiation.

**21.** An illumination apparatus according to claim 8, wherein

said radiation deflection member includes a first auxiliary optical member for leading at least one beam of radiation among the plurality of wavefront-divided beams of radiation onto a first area on a predetermined surface, and a second auxiliary optical member for deflecting another beam of radiation different from at least the above one beam of radiation among the plurality of wavefront-divided beams of radiation onto a second area on the predetermined surface, and areal sizes of the first and second areas are different from each other.

**22.** An illumination apparatus according to claim 8, wherein

said wavefront division type optical integrator includes a first unit optical system having a first focal length, and a second unit optical system having a second focal length different from the first focal length.

**23.** An illumination apparatus according to claim 8, wherein

the plurality of beams of radiation deflected by said radiation deflection member include a first beam of radiation having a first inclination to an axis parallel to the optical axis of said illumination apparatus, and a second beam of radiation having a second inclination different from the first inclination.

**24.** An illumination apparatus according to claim 8, wherein

an auxiliary optical integrator for forming a substantial planar radiation source on the basis of the beams of radiation from the plurality of radiation source images by said wavefront division type optical integrator, is disposed between said wavefront division type optical integrator and said condenser optical system, and said condenser optical system guides the radiation from the substantial planar radiation source by said auxiliary optical integrator onto the surface to be illuminated.

**25.** An illumination apparatus according to claims, 1, 8, 9, 15, 16 or 24, wherein

said radiation deflection member has a plurality of auxiliary optical member groups, said auxiliary optical member group, when n is a natural number, has 4n-pieces of auxiliary optical members, an exit surface of each of said auxiliary optical members is inclined to a fiducial surface perpendicular to the optical axis of said illumination apparatus, and when a straight line formed by projecting a normal line of the exit surface of said auxiliary optical member on the fiducial surface is set as an azimuth straight line, an angle made by the azimuth straight lines of said auxiliary optical members in said auxiliary optical member group, is 360/4n degrees.

**26.** An illumination apparatus according to claim 25, wherein

each of said auxiliary optical member groups consists of four pieces of said auxiliary optical members, and an angle made by the azimuth straight lines of said four auxiliary optical members in said auxiliary optical member group, is 90 degrees.

**27.** An illumination apparatus according to claim 26, wherein

said plurality of auxiliary optical member groups include a first auxiliary optical member group and a second auxiliary optical member group; and
an angle made by a set of the azimuth straight lines of said four auxiliary optical members in said first auxiliary optical member group and by a set of the azimuth straight lines of said four auxiliary optical members in said second auxiliary optical member group, is 45 degrees.

**28.** An illumination apparatus according to claim 27, wherein

the beam of radiation through said first auxiliary optical member group is guided onto the first area on the predetermined surface; and the beam of radiation through said second auxiliary optical member group is guided onto the second area on the predetermined surface; and
areal sizes of the first and second areas are different from each other.

**29.** An illumination apparatus according to claim 28, wherein

the first and second areas are at least partially overlapped with each other on the predetermined surface.

**30.** An illumination apparatus according to claim 27, wherein

said wavefront division type optical integrator has a plurality of unit optical systems provided corresponding respectively to said auxiliary optical members; and
a focal length of each of said unit optical systems corresponding to said first auxiliary optical member group is different from a focal length of each of said unit optical systems corresponding to said second auxiliary optical member group.

**31.** An illumination apparatus according to claim 27, wherein

when an angle made by the fiducial surface and the exit surface of said auxiliary optical member within a plane containing the azimuth straight line and the straight line parallel to the optical axis, is set as an apex angle of said auxiliary optical member, said a plurality of auxiliary optical members include a first auxiliary optical member having a first apex angle and a second auxiliary optical member having a second apex angle different from the first apex angle.

**32.** An illumination apparatus according to any one of claims 8, 9 and 11 through 21, wherein

at least one beam of radiation among the plurality of beams of radiation deflected by said radiation deflection member, is guided onto an area that does not contain the optical axis on the predetermined surface.

**33.** A projection exposure apparatus for illuminating a mask with the radiation by use of an illumination apparatus for supplying exposure radiation, and projecting a pattern on said mask on a workpiece through a projection optical system, comprising:

said illumination apparatus as set forth in claim 32, wherein
a predetermined surface is conjugate with a pupil surface of said projection optical system or a portion in the vicinity of the pupil surface.

**34.** A projection exposure apparatus according to claim 33, wherein

a radiation intensity distribution on the predetermined surface is a distribution in which a radiation intensity in an area that does not contain the optical axis is larger than in an area containing the optical axis.

**35.** A projection exposure apparatus according to claim 4, wherein

the radiation intensity distribution on the predetermined surface contains any one of an annular shape, a bipolar shape, and a quadrupolar shape.

**36.** An illumination apparatus according to any one of claims 8, 9 and 11 through 21, wherein

an auxiliary optical integrator for forming a substantial planar radiation source on the basis of the beams of radiation from the plurality of radiation source images by said wavefront division type optical integrator, is disposed between said wavefront division type optical integrator and said condenser optical system; and
said condenser optical system guides the radiation from the substantial planar radiation source by said auxiliary optical integrator onto the surface to be illuminated.

**37.** An illumination apparatus according to claim 36, further comprising:

a relay optical system for leading the beam of radiation from said wavefront division type optical integrator to said auxiliary optical integrator; and

an aperture stop having at least two or more apertures,

wherein each of the beams of radiation deflected in at least two or more directions different from each other by said radiation deflection member, pass through at least two or more apertures.

**38.** An illumination apparatus according to claim 36, further comprising;

an aperture stop disposed between said auxiliary optical integrator and the surface to be illuminated and having at least two or more apertures,

wherein said auxiliary optical integrator is a wavefront division type optical integrator having a plurality of unit optical systems,

the beams of radiation deflected in at least the two or more directions different from each other by said radiation deflection member, are overlapped with each other on at least two areas on an exit surface of said auxiliary optical integrator, and

incident surfaces of at least two unit optical systems corresponding respectively to two or more apertures among the plurality of unit optical systems in said auxiliary optical integrator, are embraced respectively by at least two areas.

**39.** An illumination apparatus according to claim 36, wherein

said auxiliary optical integrator is an internal surface reflection type optical integrator; and the respective beams of radiation deflected in at least the two or more directions different from each other by said radiation deflection member, are incident on said internal surface reflection type optical integrator in at least two or more directions different from each other.

**40.** An illumination apparatus according to any one of claims 8, 14, 17 through 19, and 24, wherein

said radiation deflection member takes a configuration containing at least partially a cone shape.

**41.** An illumination apparatus according to claim 40, wherein

the cone shape is at least a part of a conical shape.

**42.** An illumination apparatus according to claim 41, wherein

an inclined surface of the conical shape is a surface obtained by rotating a straight line about a predetermined axis.

**43.** An illumination apparatus according to claim 41, wherein

the inclined surface of the conical shape is a surface obtained by rotating a curved line about a predetermined axis.

**44.** An illumination apparatus according to claim 41, wherein

said radiation deflection member includes a first auxiliary optical member containing at least partially a conical shape, and a second auxiliary optical member containing at least partially a conical shape; and

an angle, corresponding to an apex angle of the cone, of said first auxiliary optical member and an angle, corresponding to an apex angle of the cone, of said second auxiliary optical member, are different from each other.

**45.** An illumination apparatus according to claim 40, wherein

the portion of the cone is at least a part of a polygonal cone.

**46.** An illumination apparatus according to claim 45, wherein

an inclined surface of the polygonal cone is a flat surface.

**47.** An illumination apparatus according to claim 45, wherein

an inclined surface of the polygonal cone is a curved surface.

**48.** An illumination apparatus according to claim 45, wherein

said radiation deflection member includes a first auxiliary optical member containing at least partially a polygonal cone shape, and a second auxiliary optical member containing at least partially a polygonal cone shape; and

an angle made by the inclined surface and a normal line of a bottom surface of the polygonal cone of said first auxiliary optical member and an angle made by the inclined surface and a normal line of a bottom surface of the polygonal cone of said second auxiliary optical member, are different from each other.

49. An illumination apparatus according to claim 45, wherein

the polygonal cone shape includes a first inclined surface in which the angle made by the normal line of the bottom surface of the polygonal cone shape is a first angle; and a second inclined surface in which the angle made by the normal line of the bottom surface of the polygonal cone shape is a second angle different from the first angle.

50. A projection exposure apparatus for illuminating a mask with the radiation by use of an illumination apparatus for supplying exposure radiation, and projecting a pattern on said mask on a workpiece through a projection optical system, comprising:

said illumination apparatus according to any one of claims 1 to 5 and 8 to 24, wherein said radiation source supplies the exposure radiation.

51. A projection exposure apparatus according to claim 50, further comprising another optical integrator, so provided as to be exchangeable with at least said wavefront division type optical integrator, for forming a substantial planar radiation source on the basis of the beams of radiation from said radiation source.

52. A projection exposure apparatus according to claim 51, further comprising:

an input unit for inputting data about a type of said mask, wherein said wavefront division type optical integrator is replaced with said another optical integrator on the basis of the data given from said input unit.

53. A projection exposure apparatus according to claim 52, wherein

said input unit is a console.

54. A projection exposure apparatus according to claim 52, wherein

said input unit reads a mark formed on said mask.

55. An exposure method of illuminating a mask with exposure radiation in an ultraviolet region and projecting a pattern on said mask on a workpiece through a projection optical system, comprising:

a step of using said projection exposure apparatus as forth in claim 51.

56. An exposure method according to claim 55, further comprising:

a step of inputting data about a type of said mask; and a step of exchanging a wavefront division type optical integrator with another optical integrator on the basis of the data inputted.

57. An exposure method comprising:

a step of illuminating a mask with exposure radiation in an ultraviolet region; and a step of projecting a device pattern on said mask on a workpiece through a projection optical system, wherein said step of projecting the device pattern on said workpiece is executed by use of said projection exposure apparatus as set forth in claim 51.

58. An exposure method of illuminating a mask with exposure radiation in an ultraviolet region and projecting a pattern on said mask on a workpiece through a projection optical system, comprising:

a step of using said projection exposure apparatus as set forth in claim 50.

59. An exposure method comprising:

a step of illuminating a mask with exposure radiation in an ultraviolet region; and a step of projecting a device pattern on said mask on a workpiece through a projection optical system, wherein said step of projecting the device pattern on said workpiece is executed by use of said projection exposure apparatus as set forth in claim 50.

60. An illumination apparatus for illuminating a surface to be illuminated with the radiation, comprising:

a radiation source for generating a beam of radiation having a predetermined wavelength; a radiation deflection member for wavefront-dividing the beam of radiation emitted from said radiation source into at least six beams of radiation, and deflecting at least the six beams of radiation subjected to the wavefront division in directions different from each other;

an optical integrator for forming a planar radiation source in a predetermined configuration on the basis of the beams of radiation via said radiation deflection member; and

a condenser optical system for leading the beams of radiation from said wavefront-division type optical integrator onto the surface to be illuminated, wherein

at least some of at least the six beams of radiation deflected by said radiation deflection member are guided onto an area that does not contain the optical axis on a predetermined surface.

**61.** A projection exposure apparatus for illuminating a mask with the radiation by use of an illumination apparatus for supplying exposure radiation and projecting a pattern on said mask on a workpiece through a projection optical system, comprising:

said illumination apparatus as set forth in claim 60, wherein

a predetermined surface is conjugate with a pupil surface of said projection optical system or a portion in the vicinity of the pupil surface.

**62.** An illumination apparatus according to any one of claims 1 through 24, wherein

a radiation intensity distribution on a surface having a relation of Fourier transform with the surface to be illuminated or on a surface in the vicinity of the former surface, is substantially an ununiform distribution.

**63.** A projection exposure apparatus for illuminating a mask with the radiation by use of an illumination apparatus for supplying exposure radiation and projecting a pattern on said mask on a workpiece through a projection optical system, comprising:

said illumination apparatus as set forth in claim 62, wherein

a surface having a relation of Fourier transform is substantially conjugate with a pupil surface of said projection optical system.

**64.** An illumination apparatus according to any one of claims 1 through 5, wherein said plurality of auxiliary optical members are disposed between said unit optical systems and the surface to be illuminated.

FIG. 1

# FIG. 2A

53
54
52
55
51
105
Y
Z
X

# FIG. 2B

83
84
82
85
81
108
Y
Z
X

# FIG. 3A

510

Y

X ⊗ → Z

# FIG. 3B

510

Y

Z ⊙ → X

# FIG. 3C

510

51

Y

X ⊗ → Z

# FIG. 3D

51

510

Y

Z ⊙ → X

# FIG. 3E

7

Y

X ← ⊗ Z

# FIG. 4A

# FIG. 4B

# FIG. 5

# FIG. 6A  FIG. 6B  FIG. 6C  FIG. 6D

# FIG. 6E  FIG. 6F  FIG. 6G  FIG. 6H

# FIG. 6I  FIG. 6J

# FIG. 6K

# FIG. 7A

# FIG. 7B

# FIG. 7C

# FIG. 7D

# FIG. 7E

# FIG. 7F

# FIG. 7G

## FIG. 8

# FIG. 9

# FIG. IOA

# FIG. IOB

# FIG. 11A

An

# FIG. 11B

154

Y
X⊗ ——→ Z

# FIG. 11C

A1

154

Y
Z⊙ ——→ X

# FIG. 11D

7

Y
X←—— ⊗Z

# FIG. 12A

# FIG. 12B

LS

# FIG. 12C

7

# FIG. 13A

LS

# FIG. 13B

LS

# FIG. 13C

P

# FIG. 13D

P

# FIG. 14A

# FIG. 14B

# FIG. 14C

# FIG. 14D

# FIG. 14E

# FIG.14F

# FIG. 14G

# FIG. 14H

# FIG. 14I

# FIG. 14J

# FIG. 14K

## FIG. 15A

## FIG. 15B

# FIG. 16A

# FIG. 16B

# FIG. 16E

# FIG. 16C

# FIG. 16D

# FIG. 16F

# FIG. 16G

# FIG. 17A FIG. 17B

# FIG. 17F

# FIG. 17E

# FIG. 17J

# FIG. 17G

# FIG. 17I

# FIG. 17C FIG. 17D

# FIG. 17H

# FIG. 17K

# FIG. 17L

# FIG. 18A

# FIG. 18B

# FIG. 19

EP 1 069 600 A1

# FIG. 20A

# FIG. 20B

# FIG. 21A

EL

OMA

θ

θ

θ

Y

X

Z

451

# FIG. 21B

Y

OMA

θ

Z

EL

X

O

CL

P

AXE

Y

X

Z

# FIG. 21C

EL

O

OMA

P

AXE

Y

θ

X

Z

CL

# FIG. 22 A

# FIG. 22B

# FIG. 22C

# FIG. 22D

## FIG. 23A

## FIG. 23B

## FIG. 23C

## FIG. 23D

## FIG. 23E

# FIG. 24A

# FIG. 24B

# FIG. 24C

# FIG. 24D

# FIG. 25A

# FIG. 25B

# FIG. 25C

# FIG. 25D

FIG. 26A

FIG. 26B

FIG. 26C

EP 1 069 600 A1

# FIG. 27

# FIG. 28

START

101 — VAPOR-DEPOSIT
METALLIC FILM ON WAFER

102 — COAT PHOTORESIST
ON THE METALLIC FILM

103 — TRANSFER RETICLE PATTERN IMAGE
ON EACH SHOT AREA ON THE WAFER USING
EXPOSURE APPARTUS PROVIDED WITH PROJECTION
OPTICAL SYSTEM OF 1 ST EMBODIMENT

104 — DEVELOPE PHOTORESIST
ON THE WAFER

105 — CONDUCT ETCHING BY
MAKING RESIST PATTERN
AS A MASK ON THE WAFER

NEXT STEP

EP 1 069 600 A1

## INTERNATIONAL SEARCH REPORT

International application No.

PCT/JP99/01442

**A. CLASSIFICATION OF SUBJECT MATTER**
Int.Cl$^6$  H01L21/027, G03F7/20

According to International Patent Classification (IPC) or to both national classification and IPC

**B. FIELDS SEARCHED**

Minimum documentation searched (classification system followed by classification symbols)
Int.Cl$^6$  H01L21/027, G03F7/20

Documentation searched other than minimum documentation to the extent that such documents are included in the fields searched
Jitsuyo Shinan Koho        1922-1996    Toroku Jitsuyo Shinan Koho    1994-1999
Kokai Jitsuyo Shinan Koho   1971-1999    Jitsuyo Shinan Toroku Koho    1996-1999

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| E, X | JP, 11-97340, A (Omron Corp.),<br>9 April, 1999 (09. 04. 99) (Family: none) | 1-9, 14-39,<br>50, 60-64 |
| A | JP, 10-50599, A (Nikon Corp.),<br>20 February, 1998 (20. 02. 98) (Family: none) | 1-64 |
| A | JP, 9-45607, A (Canon Inc.),<br>14 February, 1997 (14. 02. 97) (Family: none) | 1-64 |

☐ Further documents are listed in the continuation of Box C.          ☐ See patent family annex.

\* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>8 June, 1999 (08. 06. 99) | Date of mailing of the international search report<br>15 June, 1999 (15. 06. 99) |
|---|---|
| Name and mailing address of the ISA/<br>Japanese Patent Office | Authorized officer |
| Facsimile No. | Telephone No. |

Form PCT/ISA/210 (second sheet) (July 1992)

60